(19) Europäisches Patentamt
European Patent Office
Office européen des brevets

(11) EP 4 394 841 A1

# (12) EUROPEAN PATENT APPLICATION

(43) Date of publication:
03.07.2024 Bulletin 2024/27

(21) Application number: 22217433.6

(22) Date of filing: 31.12.2022

(51) International Patent Classification (IPC):
H01J 37/244 (2006.01)

(52) Cooperative Patent Classification (CPC):
H01J 37/244; H01J 2237/2441; H01J 2237/2445;
H01J 2237/24495

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: ASML Netherlands B.V.
5500 AH Veldhoven (NL)

(72) Inventors:
• BEUKMAN, Arjan, Johannes, Anton
5500 AH Veldhoven (NL)

• VAN WEPEREN, Ilse
5500 AH Veldhoven (NL)
• SOKOLOV, Sergei
5500 AH Veldhoven (NL)
• AKBULUT, Duygu
5500 AH Veldhoven (NL)

(74) Representative: ASML Netherlands B.V.
Corporate Intellectual Property
P.O. Box 324
5500 AH Veldhoven (NL)

## (54) MULTIPLEXED READOUT FOR PARALLEL ELECTRON DETECTORS

(57) An optical multiplexer, comprising: an optical waveguide; a plurality of resonators optically coupled with the optical waveguide; and a plurality of detectors, each detector of the plurality of detectors being associated with one of the resonators, each of the resonators being tuned to an individual resonance wavelength different from resonance wavelengths of other resonators of the plurality of resonators, wherein each detector of the plurality of detectors is configured to change an optical path length or refractive index of the associated resonator.

FIG. 8B

**Description**

<u>TECHNICAL FIELD</u>

The present disclosure relates generally to a system and method for multiplexed readout of multiple detectors.

<u>BACKGROUND</u>

In manufacturing processes of integrated circuits (ICs), unfinished or finished circuit components are inspected to ensure that they are manufactured according to design and are free of defects. Inspection systems utilizing optical microscopes or charged particle (e.g., electron) beam microscopes, such as a scanning electron microscope (SEM) can be employed. As the physical sizes of IC components continue to shrink, and their structures continue to become more complex, accuracy and throughput in defect detection and inspection become more important. The overall image quality may be improved and image acquisition time decreased by application of multiple electron beams, such as by scanning of parallel electron beams over a surface simultaneously. For various applications (such as inspection), it may be desirable to obtain high quality imaging and efficient collection of surface information from multiple electron beams simultaneously, highlighting a need for using multiple electron detectors in a SEM. Although multiple electron detectors in various structural arrangements may be used to maximize collection and detection efficiencies of electrons individually, the use of multiple detectors may complicate data acquisition.

In the context of semiconductor manufacture, various surfaces need to be monitored and identified. Various solutions for surface monitoring have been proposed.

<u>SUMMARY</u>

According to an embodiment, there is provided an optical multiplexer. The optical multiplexer comprises an optical waveguide, a plurality of resonators, and a plurality of detectors. The plurality of resonators are optically coupled with the optical waveguide. Each detector of the plurality of detectors is associated with one of the resonators, and each of the resonators is tuned to an individual resonance wavelength different from resonance wavelengths of other resonators of the plurality of resonators. Each detector of the plurality of detectors is configured to change an optical path length or refractive index of the associated resonator.

In an embodiment, the detectors comprise particle detectors.

In an embodiment, each detector comprises a modulator configured to modulate a detected signal and the modulator is configured to change the optical path length or refractive index of the associated resonator based on the modulated signal.

In an embodiment, the optical multiplexer further comprises an optical source. The optical source is configured to probe the plurality of resonators by supplying a wavelength of emitted light to the optical waveguide over a wavelength range and by scanning the wavelength of emitted light over the wavelength range.

In an embodiment, the optical multiplexer further comprises an optical detector. The optical detector is configured to detect intensity as a function of wavelength of light transmitted by the optical waveguide after interaction of the light in the optical waveguide with the plurality of resonators.

According to an embodiment, there is provided a method for detection of multiple particle beams comprising detecting, by a plurality of detectors, signals corresponding to a received media;, applying, by the plurality of detectors, the detected signals to a plurality of resonators, supplying, via an optical waveguide, an optical input to the plurality of resonators, detecting, via the optical waveguide, an optical output of the plurality of resonators, determining, based on the optical output, resonance wavelengths of the plurality of resonators, and determining, based on the resonance wavelengths, the signals detected by the plurality of detectors.

In an embodiment, each of the plurality of resonators is tuned to an individual resonance wavelength different from resonance wavelengths of other resonators.

In an embodiment, determining the detected signals comprises determining, for each of the plurality of resonators, a relationship between the determined resonance wavelength and a baseline resonance wavelength, and determining, based on the relationship between the determined resonance wavelength and the baseline resonance wavelength, the detected signal applied to each of the plurality of resonators.

In an embodiment, detecting the signals corresponding to the received media further comprises modulating, by a plurality of modulators, the detected signals and wherein applying the detected signals to the plurality of resonators comprises applying, by the plurality of modulators, the modulated signals to the plurality of resonators.

In an embodiment, detecting, by the plurality of detectors, signals corresponding to the received media further comprises detecting, by the plurality of detectors, signals corresponding to particles incident on a plurality of detection areas, a given detection area within the plurality of detection areas corresponding to a given detector within the plurality of detectors and wherein determining, based on the resonance wavelengths, the signals further comprises determining, based on the resonance wavelengths, the signals corresponding to the particles incident on the plurality of detection areas.

In an embodiment, constructing an image based on the signals detected by the plurality of detectors.

According to an embodiment, an apparatus comprising the optical multiplexer of any other embodiment and a measurement system configured to measure a resonance wavelength for each of the plurality of resonators is provided.

In an embodiment, the apparatus further comprises a source configured to provide a beam of particles from which a multi-beam is derived, where the plurality of detectors are configured to detect particles after interaction of the multi-beam with a sample.

In an embodiment, the apparatus further comprises an objective lens array assembly, the objective lens array assembly configured to focus the multi-beam of sub-beams on the sample.

In an embodiment, the objective lens array assembly further comprises an objective lens array defining a plurality of apertures aligned along sub-beam paths of the multi-beam and configured to project the multi-beam towards the sample.

In an embodiment, the objective lens array further comprises the plurality of detectors, a given detector within the plurality of detectors surrounding a sub-beam path of the multi-beam.

According to an embodiment, an apparatus configured to perform the method of any other embodiment is provided.

According to another embodiment, one or more non-transitory, machine-readable medium is provided having instructions thereon, the instructions when executed by a processor being configured to perform the method of any other embodiment.

## BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:

Figure 1 is a schematic diagram illustrating an exemplary particle beam system, according to an embodiment.
Figure 2 is a schematic diagram of an exemplary particle beam tool, according to an embodiment.
Figure 3 is a schematic diagram illustrating an exemplary multi-beam particle beam tool, according to an embodiment.
Figure 4A is a schematic diagram of an exemplary objective lens array assembly for MEMS-based multi-beam apparatus for a multiple particle beam tool, according to an embodiment.
Figure 4B is schematic diagram of an exemplary objective lens array assembly for MEMS-based multi-beam apparatus for a multiple particle beam tool, according to an embodiment.
Figure 5 is a schematic side sectional view of a detector module integrated with a two-electrode objective lens array, according to an embodiment.
Figures 6A-6C are schematic diagrams of example particle detectors, according to an embodiment.
Figures 7A-7C are schematic diagrams of example optical resonators associated with particle detectors, according to some embodiments.
Figures 8A-8F are schematic diagrams of relationships between multiple resonators, according to an embodiment.
Figure 9 is a schematic diagram of multiple resonators on multiple waveguides, according to an embodiment.
Figure 10 is a flowchart that illustrates a method of detecting multiple particle beams, according to an embodiment.
Figure 11 is a block diagram of an example computer system, according to an embodiment of the present disclosure.

## DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. A patterning device (for example, a lithography device) can comprise, or can form, one or more patterns, which may correspond to one or die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

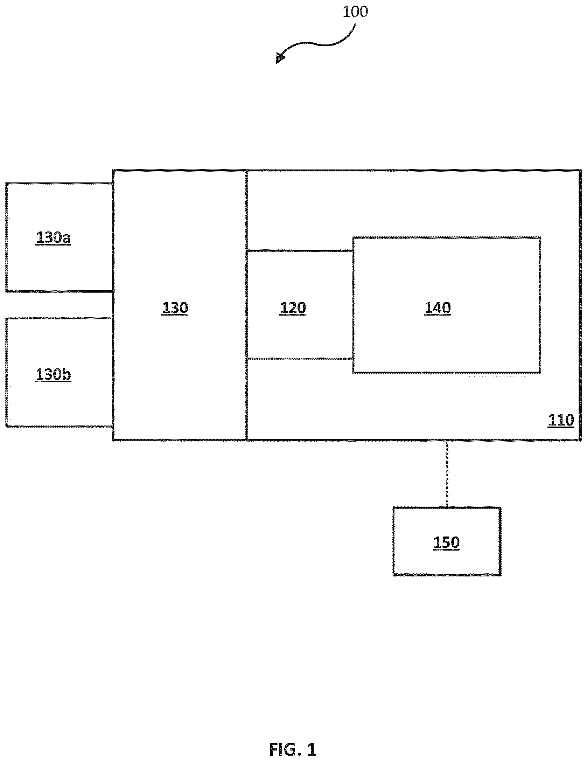

Reference is now made to Figure 1, which illustrates an exemplary particle beam system 100 consistent with embodiments of the present disclosure. As shown in Figure 1, the particle beam system 100 includes a main chamber 110, a load-lock chamber 120, a particle beam tool 140, and an equipment front end module (EFEM) 130. Particle beam tool 140 is located within main chamber 110. The exemplary particle beam system 100 may be a single or multi-beam system. A multi-beam system may be a parallel beam system. A parallel beam system may be a massive multi-beam particle system, such as a micro-electromechanical system (MEMS), including MEMS-lite systems with as many as -- 3000 particle beams, full-MEMS systems with as many as -18,000 particle beams. While the description and drawings are directed to a particle beam, it is appreciated that the embodiments are not used to limit the present disclosure to specific particles. Particles may include charged particles, such as electrons, ions, protons, etc.

EFEM 130 includes a first loading port 130a and a second loading port 130b. EFEM 130 may include additional loading port(s). First loading port 130a and second loading port 130b may receive wafer front opening unified pods (FOUPs) that contain wafers (e.g., semiconductor wafers or wafers made of other material(s)) or samples to be inspected (wafers and samples are collectively referred to as "wafers" hereafter). One or more robot arms (not shown) in EFEM 130 transport the wafers to load-lock chamber 120.

Load-lock chamber 120 is connected to a load/lock vacuum pump system (not shown), which removes gas molecules in load-lock chamber 120 to reach a first pressure below the atmospheric pressure. After reaching the first pressure, one or more robot arms (not shown) transport the wafer from load-lock chamber 120 to main chamber 110. Main chamber 110 is connected to a main chamber vacuum pump system (not shown), which removes gas molecules in main chamber 110 to reach a second pressure below the first pressure. After reaching the second pressure, the wafer is subject to inspection by particle beam tool 140. In some embodiments, the particle beam tool 140 may comprise a single-beam inspection tool. In some embodiments, the particle beam tool 140 may comprise a multi-beam inspection tool.

Controller 150 may be electronically connected to particle beam tool 140 and may be electronically connected to other components as well. Controller 150 may be a computer configured to execute various controls of particle beam system 100. Controller 150 may also include processing circuitry configured to execute various signal and image processing functions. While controller 150 is shown in Figure 1 as being outside of the structure that includes main chamber 110, load-lock chamber 120, and EFEM 130, it is appreciated that controller 150 can be part of the structure.

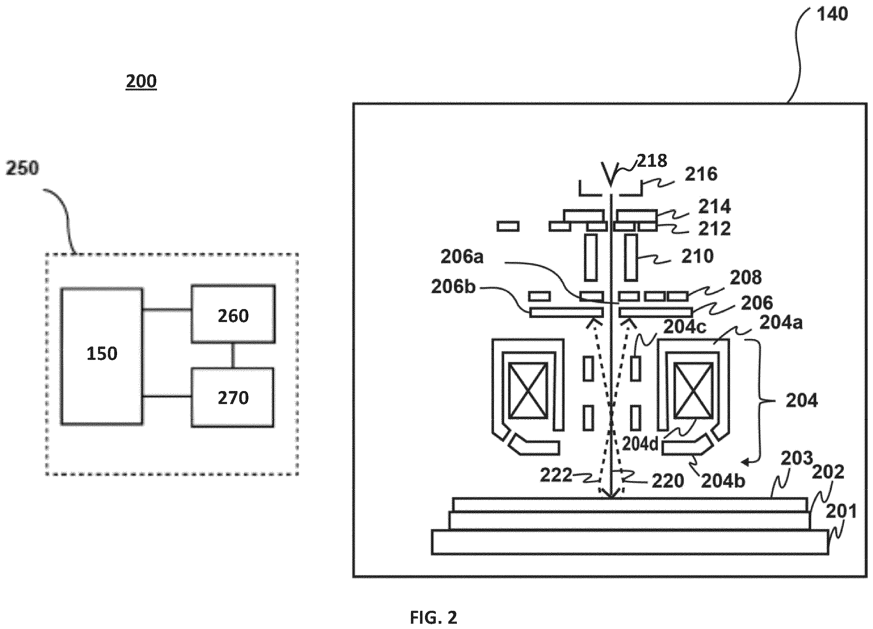

Figure 2 illustrates schematic diagram of an exemplary imaging system 200 according to embodiments of the present disclosure. Particle beam tool 140 of FIG. 2 may be configured for use in particle beam system 100. Particle beam tool 140 may be a single beam apparatus or a multi-beam apparatus. As shown in FIG. 2, particle beam tool 140 includes a motorized sample stage 201, and a wafer holder 202 supported by motorized sample stage 201 to hold a wafer 203 to be inspected. Particle beam tool 140 further includes an objective lens assembly 204, a particle detector 206 (which includes particle sensor surfaces 206a and 206b), an objective aperture 208, a condenser lens 210, a beam limit aperture 212, a gun aperture 214, an anode 216, and a cathode 218. The particle detector 206 may be a single particle detector, multiple particle detectors, contain multiple particle detector elements, etc. In one embodiment, the particle detector 206 may be a particle detector for the particle beam tool 140, which is a multi-beam tool, a parallel beam tool, a massively parallel beam tool, etc. The particle detector 206 may have one or more aperture, such as to allow penetration of one or more particle beam (such as in a forward direction from the cathode 218 to the motorized sample stage 201). The particle detector 206 may have multiple apertures, such as apparatus which correspond to one or more of multiple particle beams. Objective lens assembly 204, in some embodiments, may include a modified swing objective retarding immersion lens (SORIL), which includes a pole piece 204a, a control electrode 204b, a deflector 204c, and an exciting coil 204d. Particle beam tool 140 may additionally include an Energy Dispersive X-ray Spectrometer (EDS) detector (not shown) to characterize the materials on wafer 203.

A primary particle beam 220 is emitted from cathode 218 by applying a voltage between anode 216 and cathode 218. Primary particle beam 220 passes through gun aperture 214 and beam limit aperture 212, both of which may determine the size of particle beam entering condenser lens 210, which resides below beam limit aperture 212. Condenser lens 210 focuses primary particle beam 220 before the beam enters objective aperture 208 to set the size of the particle beam before entering objective lens assembly 204. Deflector 204c deflects primary particle beam 220 to facilitate beam scanning on the wafer. For example, in a scanning process, deflector 204c may be controlled to deflect primary particle beam 220 sequentially onto different locations of top surface of wafer 203 at different time points, to provide data for image reconstruction for different parts of wafer 203. Moreover, deflector 204c may also be controlled to deflect primary particle beam 220 onto different sides of wafer 203 at a particular location, at different time points, to provide data for stereo image reconstruction of the wafer structure at that location. Further, in some embodiments, anode 216 and cathode 218 may be configured to generate multiple primary particle beams 220, and particle beam tool 140 may include a plurality of deflectors 204c to project the multiple primary particle beams 220 to different parts/sides of the wafer at the same time, to provide data for image reconstruction for different parts of wafer 203.

Exciting coil 204d and pole piece 204a generate a magnetic field that begins at one end of pole piece 204a and terminates at the other end of pole piece 204a. A part of wafer 203 being scanned by primary particle beam 220 may be immersed in the magnetic field and may be electrically charged, which, in turn, creates an electric field. The electric field reduces the energy of impinging primary particle beam 220 near the surface of wafer 203 before it collides with wafer 203. Control electrode 204b, being electrically isolated from pole piece 204a, controls an electric field on wafer 203 to prevent micro-arching of wafer 203 and to ensure proper beam focus.

A secondary particle beam 222 may be emitted from the part of wafer 203 upon receiving primary particle beam 220. Secondary particle beam 222 may form a beam spot on particle sensor surfaces 206a and 206b of particle detector 206. Particle detector 206 may generate a signal (e.g., a voltage, a current, etc.) that represents an intensity of the beam spot, and provide the signal to an image processing system 250. The intensity of secondary particle beam 222, and the resultant beam spot, may vary according to the external or internal structure of wafer 203. Moreover, as discussed above, primary particle beam 220 may be projected onto different locations of the top surface of the wafer or different sides of the wafer at a particular location, to generate secondary particle beams 222 (and the resultant beam spot) of different intensities. Therefore, by mapping the intensities of the beam spots with the locations of wafer 203, the processing system may reconstruct an image that reflects the internal or surface structures of wafer 203.

Imaging system 200 may be used for inspecting a wafer 203 on motorized sample stage 201, and comprises a particle beam tool 140, as discussed above. Imaging system 200 may also comprise an image processing system 250 that includes an image acquirer 260, storage 270, and controller 150 (which may be the controller 150 of Figure 1). Image acquirer 260 may comprise one or more processors. For example, image acquirer 260 may comprise a computer, server, mainframe host, terminals, personal computer, any kind of mobile computing devices, and the like, or a combination thereof. Image acquirer 260 may connect with a particle detector 206 of particle beam tool 140 through a medium such as an electrical conductor, optical fiber cable, portable storage media, IR, Bluetooth, internet, wireless network, wireless radio, or a combination thereof. Image acquirer 260 may receive a signal from particle detector 206 and may construct an image. Image acquirer 260 may thus acquire images of wafer 203. Image acquirer 260 may also perform various post-processing functions, such as generating contours, superimposing indicators on an acquired image, and the like. Image acquirer 260 may be configured to perform adjustments of brightness and contrast, etc. of acquired images. Storage 270 may be a storage medium such as a hard disk, cloud storage, random access memory (RAM), other types of computer readable memory, and the like. Storage 270 may be coupled with image acquirer 260 and may be used for saving scanned raw image data as original images, and post-processed images. Image acquirer 260 and storage 270 may be connected to controller 150. In some embodiments, image acquirer 260, storage 270, and controller 150 may be integrated together as one control unit.

In some embodiments, image acquirer 260 may acquire one or more images of a sample based on an imaging signal received from particle detector 206. An imaging signal may correspond to a scanning operation for conducting charged particle imaging. An acquired image may be a single image comprising a plurality of imaging areas. The single image may be stored in storage 270. The single image may be an original image that may be divided into a plurality of regions. Each of the regions may comprise one imaging area containing a feature of wafer 203.

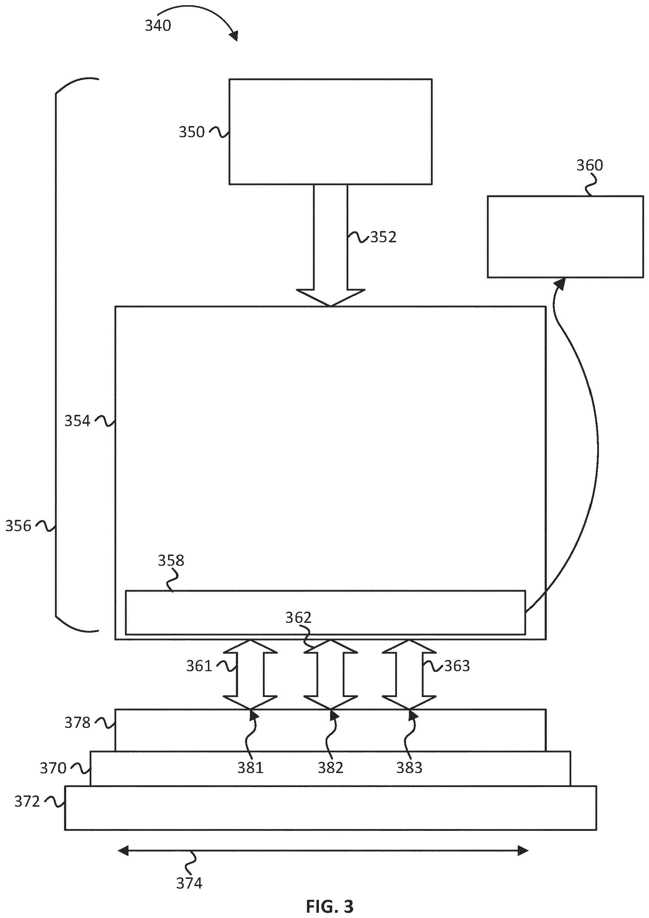

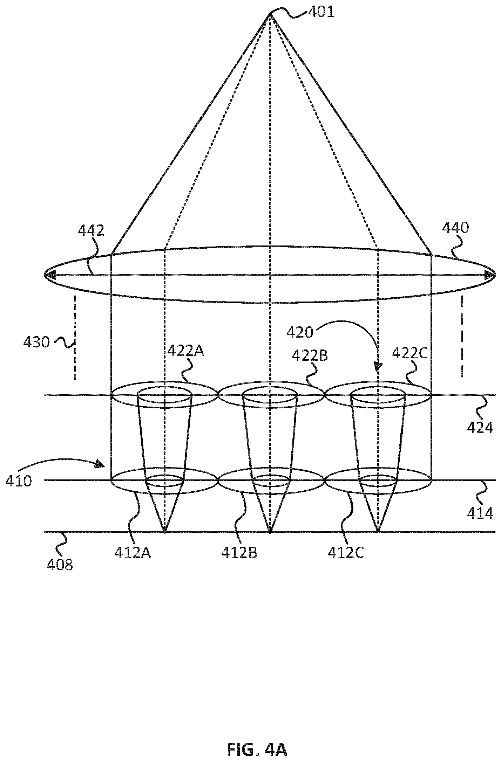

In particle beam tools, signals generated by detection of secondary electrons and backscattered electrons (or other particles) are used in combination for imaging surfaces, detecting and analyzing defects, obtaining topographical information, morphological and compositional analysis, among others. By using multiple particle beams, as well as multiple detectors, it may be possible to increase imaging efficiency, throughput, etc. and decrease imaging latency time, particle beam deflection range, sample scanning range, etc. It may also be beneficial to improve particle detection efficiency, such as by use of multiple particle detectors, to obtain high-quality imaging, while maintaining high throughput such as by using multiple particle beams. Detection of reflected particles corresponding to multiple parallel beams may increase decrease scanning time, increase information acquired, etc. Additional multi-beam particle beam apparatuses are now described, which may be used additionally or alternatively, for multiple particle beam tools. Aspects described in relation to Figures 3 and 4A-4B may be used in concert with the apparatuses described in relation to Figures 1 and 2.

Figure 3 is a schematic diagram illustrating an exemplary multi-beam particle beam tool. Figure 3 is a block diagram illustrating an exemplary multi-beam particle beam tool 340, which may be part of the particle beam system 100 of Figure 1. The multi-beam particle beam tool 340 comprises a particle source 350, a projection apparatus 354, a motorized stage 372, and a sample holder 370. The particle source 350 may be an electron source. The multi-beam particle beam tool may comprise a particle beam system and a sample holder (e.g., the sample holder 370). The sample holder 370 is configured to support a sample 378. The particle source 350 and the projection apparatus 354 may together be referred to as an illumination apparatus 356, which may provide particle illumination to the sample 378. The sample holder 370 may be actuated by the motorized stage 372, such as to perform a raster scan or other scan of the area of the sample 378, which may be part of the multi-beam particle beam tool 340. The sample holder 370 is supported by the motorized stage 372 so as to present the sample 378 (e.g., a wafer, mask, etc.) for inspection. Alternatively or additionally, the illumination apparatus 356 may be actuated (e.g., motorized) to illuminate different areas of the sample 378. The multi-beam particle beam tool 340 further comprises a particle detection device 358.

The particle source 350, which may be a charge particle source, an electron source, etc., may comprise a cathode (not depicted) and an extractor or anode (not depicted). During operation, the particle source 350 may be configured to emit electrons as primary electrons from the cathode. The primary electrons may be extracted or accelerated by the extractor and/or the anode to form a primary particle beam 352., which may be a primary electron beam.

The projection apparatus 354 is configured to convert the primary particle beam 352 into a plurality of sub-beams 361, 362, 363, which may be the multiple beams of the multi-beam particle beam tool 340. The projection apparatus is configured to direct each of the sub-beams 361, 362, 363 onto the sample 378. Although only three sub-beams (e.g., sub-beams 361, 362, 363) are depicted, for the sake of simplicity, there may be tens, hundreds, or thousands of sub-beams (for example, -1,800 sub-beams, -30,000 sub-beams, etc.). The sub-beams may also be referred to as "beamlets" or "beams", while the primary particle beam 352 may be referred to as a "beam" or "primary beam"-herein the term "beam" does not require that a beam be of a certain strength or pre or post beam splitting.

A controller (e.g., the controller 150 of Figures 1 or 2) may be connected to various parts of the multi-beam particle beam tool 340, such as to the particle source 350, the particle detection device 358, projection apparatus 354, and motorized stage 372. The controller may perform various image and signal processing functions. The controller may also generate various control signals to govern operations of the particle beam inspection apparatus (e.g., the particle beam system 100 of Figure 1), including the multi-beam particle beam tool 340 (which may be the particle beam tool 140 of Figure 1).

The projection apparatus 354 may be configured to focus sub-beams 361, 362, 363 onto the sample 378 for inspection (or other operations) and may form corresponding probe spots 381, 382, 383 on the surface of the sample 378. The number of probe spots may approximately correspond to the number of sub-beams (for example, three sub-beams 361, 362, 363 and three probe spots 381, 382, 383 are depicted), where the correspondence may not be exact. For example, two sub-beams may correspond to a single probe spot (such as due to misdirection), a sub-beam may correspond to two probe spots, such as due to lens aberrations, or a sub-beam may correspond to substantially no probe spots, due to incomplete beam aperture. The projection apparatus 354 may be configured to deflect the sub-beams 361, 362, 363 to scan probe spots 381, 382, 383 across scanning areas of a section of the surface of the sample 378. The sub-beams 361, 362, 363 may penetrate into the bulk of the sample 378, such as close to the surface, where penetration depth may depend on the energy of the particles of the sub-beams 361, 362, 363. The scanning areas may be individual (e.g., non-overlapping squares), collective (e.g., the sub-beams may cross or intertwine paths such as during a raster of the sample 378), partially overlapping, such as on the edges, etc. The sub-beams 361, 362, 363 may be scanned in unison (such as by a substantially similar deflection field) or scanned individually, such as by individual actuators. In response to incidence of particles, such as of the sub-beams 361, 362, 363 on the probe spots 381, 382, 383 on the sample 378, particles are generated from the sample 378, which may include backscattered electrons (BSEs), secondary electrons (SEs), etc. SEs may have electron energies ≤ 50 eV, while BSEs may have electron energies between 50 eV and a landing energy of the sub-beams 361, 362, 363.

The particle detection device 358 is configured to detect particles emitted, reflected, etc. from the sample 378, which may be BSEs, SEs, etc. The particle detection device 358 is configured to generate signals corresponding to the detection of the particles, which are sent to the controller or a signal processing system (not depicted), such as to construct images of areas of the sample 378 scanned by the probe spots 381, 382, 383. The particle detection device 358 may be incorporated into the projection apparatus 354 or may be separate from the projection apparatus 354. For example, the particle detection device 358 may be incorporated into a secondary particle column provided to direct particles (e.g., SEs or BSEs) to the particle detection device 358.

The controller may comprise an imaging processing system that includes an image acquirer 360 and a storage device. For example, the controller may comprise a processor, computer, server, mainframe, cloud, terminals, personal computing, mobile computing devices, etc. The image acquirer 360 may comprise part of a processing element of the controller. That is, the image acquirer 360 may operate on or by at least one or more processors. The image acquirer 360 may be communicatively coupled to the particle detection device 358 of the particle beam inspection apparatus (e.g., the particle beam system 100 of Figure 1), such as by electrical conductor, optical fiber, IR, Bluetooth, wireless network, wireless radio, etc. which may permit communication between the image acquirer 360 and the particle detection device 358. The image acquirer 360 may receive one or more signals from the particle detection device 358, may process the data comprising the signal, and may construct an image from the data. The data may comprise signals from multiple particle detection elements, which may make up the particle detection device 358. The data may comprise signals from one or more data collection (e.g., particle accumulation) time frame. The data may correspond to data forming various pixels of an image or which may be processes to obtain pixel values for various pixels of the image. The image acquirer 360 may thus acquire images of the sample 378 (or signals which correspond to images of the sample 378). The image acquirer 360 may also perform various post-processing functions, such as generating contours, superimposing indicators on an acquired image, comparing an acquired image to a previously acquired image, etc. The image acquirer 360 may be configured to perform adjustments of brightness, contrast, various pixel values, smoothing, etc. of the acquired image. The image acquirer may be configured to store the image in a storage medium, such as a hard disk, flash drive, cloud, random access memory (RAM), or any appropriate type of computer-readable memory. The storage medium may be communicatively coupled to the image acquirer 360 and may be used for saving signals, raw image data, post-processed images, information about processing, etc.

The image acquirer 360 may acquire one or more images of the sample 378 based on one or more signal received from the particle detection device 358. The one or more signals may correspond to scanning operations occurring during particle detection. The acquired image may be a single image which is comprised of a plurality of imaging areas, such as corresponding to the sub-beams 361, 362, 363 or corresponding to detection elements of the particle detection device 358. The single image may be stored in the storage medium. The single image may be an image which is divided into a plurality of regions, such as for storage, by image recognition, etc. Each of the plurality of regions may contain a feature of the sample 378. The acquired image may comprise multiple images of a single area of the sample 378 images multiple times (e.g., re-scanned) over a time period. The multiple images may be stored in the storage medium. The controller may be configured to perform image processing steps with multiple images of the same area of the sample 378 instead or additionally to performing image processing steps with multiple images of different areas of the sample 378.

The controller may include measurement circuitry (e.g., analog to digital converters) to obtain a distribution of the detected particles. The particle distribution data, which may be collected during an accumulation time, may be used in combination with the data corresponding to scan path of the sub-beams 361, 362, 363 on the surface of the sample 378 to reconstruct images of the sample 378. The reconstructed images can be used to reveal features of the structures of the sample 378. The reconstructed images may be used to reveal any defects (for example, incomplete etch) that may exist in the sample.

The controller may control the motorized stage 372 (or a motorized positioner of the illumination apparatus 356) to move the sample 378 during inspection of the sample 378. The controller may enable the motorized stage 372 to move the sample in one or more directions, such as a direction 374, where the movement may be continuous, such as at a constant speed) during inspection of the sample 378. The controller may control movement of the motorized stage 372 so that it changes the speed or direction of the movement of the sample 378 depending on various parameters, such as by detecting that an edge of the sample 378 is reached, based on a layout of the sample 378, etc. For example, the controller may control the speed of the motorized stage 372 depending on the characteristics of the inspection steps of the scanning process. The controller may control the motorized stage 372 based on a determined routine (e.g., a recipe) or based on signals acquired during the imaging, such as based on a total intensity of signal determined. For example, a speed of the motorized stage 372 may be slowed if the particle detection intensity falls below a threshold and an accumulation time is increased.

The multi-beam particle beam tool 340 may include an objective lens array assembly. The objective lens array assembly may be configured to focus a multi-beam comprising sub-beams on a sample. The objective lens array assembly may be incorporated into the particle beam system of the multi-beam particle beam tool 340. The objective lens array assembly may include both elements for creation of sub-beams from a primary beam and particle detector elements.

Figure 4A is a schematic diagram of an exemplary objective lens array assembly for a multi-beam apparatus in a multiple particle beam tool. The objective lens array assembly may be found withing the multi-beam particle beam tool 340 of Figure 3. The objective lens array assembly may contain a particle source 401, which may be the particle source 350 of Figure 3 or any other appropriate particle source. The objective lens array assembly is described in reference to a sample 408, which may be the sample 378 of Figure 3, such as supported by the sample holder 370 and the motorized stage 372 or any other appropriate support (including non-motorized support). The objective lens array assembly comprises planar elements defining a plurality of apertures aligned along paths of sub-beams of a primary particle beam produced by the particle source 401. The objective lens assembly array contains an objective lens array 410. The objective lens array 410 may contain a plurality of planar elements of the objective lens assembly array. The planar elements of the objective lens array 410 may be configured to act as electrodes. The planar elements may, for example, be metallic or configured to be connected to respective potential sources. The planar elements of the objective lens array 410 may be referred to as electrodes, plate electrodes, electrode array, plate electrode array, etc. A plurality of apertures that are aligned along each of the sub-beam paths may be defined in respective planar elements (e.g.,

electrodes) of the objective lens array 410. The positions of the apertures defined in the planar elements (e.g., electrodes) of the objective lens array 410 may correspond to the positions of apertures in other planar elements of the object lens array assembly (such as the control lens array 420 described below). For example, a set of apertures in multiple planar elements or electrodes may lie along a path of a given sub-beam (such as the objective lens 412A may lie along a sub-beam path which also passes through a control lens 422A). Each of the apertures aligned along a given sub-beam path may operate as an objective lens or electrode, including in concert with others of the apertures along the given sub-beam path. The objective lens array assembly may be considered to be a set of objective lenses, each corresponding to a given sub-beam, which projects the plurality of sub-beams onto the sample 408. The objective lens array 410 comprises a plurality of objective lenses. As previously described in reference to Figure 3, "each" is use herein for a general correspondence and does not require an exact one-to-one relationship, such as between apertures and sub-beams, and items described as "each" may contain instead more than one, one, or less than one (including zero) element in relation to another element.

For ease of description, the objective lens array 410 is depicted as containing multiple oval shapes representing individual lenses (e.g., 412A, 412B, 412C), where each lens 412A-412C represents a lens in the objective lens array 410. The oval shape of the lenses 412A-412C is used by convention to represent a lens, as analogous to an optical lens, where it should be understood that particle lenses may have a different shape. Lenses for particles, including charged particles, may operate electrostatically, electromagnetically, magnetically, etc., and may not require a physical element exhibiting a biconvex shape. As described herein, lens arrays may instead comprise multiple planar elements defining apertures.

In some embodiments, the planar elements of the object lens array assembly further comprise a control lens array 420. The control lens array 420 may comprise a plurality of control lenses 422A-422C. The control lenses 422A-422C may comprise at least two planar elements configured to act as electrodes, which may be connected to respective potential sources. Although only three control lenses 422A-422C and three objective lenses 412A-412C are depicted, it should be understood that many multiples of these lenses may be provided, including up to -1,800, -30,000 lenses for each set of lenses.

In an embodiment the control lens array 420 may be considered to be additional electrodes of the objective lens array 410 enabling additional functionality of the respective objective lenses 412A-412C of the objective lens array 410. In such an arrangement, the control lenses 422A-422C may be considered to be part of the corresponding objective lenses 412A-412C, including to such an extent that the control lenses 422A-422C may only be referred to as being a part of the objective lenses 412A-412C.

In an arrangement, the control lens array 420 may be used to optimize a beam opening angle with respect to the demagnification of the beam or to control the beam energy delivered to the objective lens array 410. Use of the control lens array enables the objective lens array 410 to operate at an optimal electric field strength (where "optimal" denotes better than some values, such as for power requirements, distortion, etc. and does not require that the value be a universal or even local optimum).

In an embodiment, the landing energy (e.g., of the particles from the particle source 401 on the sample 408) may be controlled to a desired value, such as in a predetermined range (e.g., from 1000 eV to 5000 eV). Resolution may deteriorate below a minimum landing energy, where it may be necessary to reduce the lens strength of, and electric fields within, the objective lenses 412A-412C in order to maintain a minimum spacing between the sample 408 and objective lenses 412A-412C or detector.

The landing energy may be controlled primarily by varying the energy of the particles exiting the control lenses 422A-422C. The potential differences within the objective lenses 412A-412C may be preferably kept constant while the potential differences within the control lenses 422A-422C are varied, so that the electric field within the objective lenses 412A-412C remains as high as possible. The potentials applied to the control lenses 422A-422C may also be used to optimize the beam opening angle and demagnification. The control lenses 422A-422C may function to change the demagnification in view of changes in landing energy.

In the embodiment of Figure 4A, the electron-optical system comprises the particle source 401. The particle source 401 provides a beam of particles (e.g., charged particles, electrons, etc.). The multi-beam focused on the sample 408 may be derived from the particle beam provided by the particle source 401. Sub-beams may be derived from the beam, for example, using a beam limiter defining an array of beam-limiting apertures. The particle source 401 may be a high brightness thermal field emitter, where comprises between brightness and total emission current may be made. In the example depicted in Figure 4A, a collimator is provided up-beam of the objective lens array 410. The collimator may be a macro collimator 440. The macro collimator 440 acts on the beam from the particle source 401 before the beam has been split into a multi-beam (e.g., sub-beams). The macro collimator 440 bends respective portions of the beam by an amount effective to ensure that a beam axis of each of the sub-beams derived from the beam is incident on the sample 408 substantially normally (e.g., at substantially 90° to the nominal surface of the sample 408). The macro collimator 440 applies a macroscopic collimation to the beam. The macro collimator 440 may thus act on all of the sub-beams rather than comprising an array of collimator elements that are each configured to act on a different individual portion of the beam. The macro collimator 440 may comprise a magnetic lens or magnetic lens arrangement comprising a plurality of magnetic lens sub-units (e.g., a plurality of electromagnets forming a multi-pole arrangement). Alternatively or additionally, the macro collimator 440 may be at least partially implemented electrostatically. The macro collimator 440 may comprise an electrostatic lens or electrostatic lens arrangement comprising a plurality of electrostatic lens sub-units. The macro collimator 440 may use a combination of magnetic and electrostatic lenses. The macro collimator 440 may have a diameter 442, which may be approximately 200 mm.

In the embodiment depicted in Figure 4A, a macro scan deflector 430 is provided to cause sub-beams to be scanned over the sample 408. The macro scan deflector 430 deflects respective portions of the beam to cause the sub-beams to be scanned over the sample 408. In an embodiment, the macro scan deflector Y56 comprises a macroscopic multi-pole deflector, for example with eight poles or more. The deflection is such as to cause sub-beams derived from the beam to be scanned across the sample 408 in one direction (e.g., parallel to a single axis, such as an X axis) or in two directions (e.g., relative to two non-parallel axes, such as X and Y axes). The macro scan deflector 430 acts macroscopically on all of the beam rather than comprising an array of elements that are each configured to act on a different individual portion of the beam. In the embodiment shown, the macro scan deflector 430 is provided between the macro collimator 440 and the control lens array 420.

In one embodiment, the macro scan deflector 430 may be instead or additionally a scan-deflector array. The scan-deflector array may comprise a plurality of scan deflectors. The scan-deflector array may be formed using MEMS manufacturing techniques. Each scan deflector of the scan deflector array may scan a respective sub-beam over the sample 408. The scan-deflector array may thus comprise a scan deflector for each sub-beam. Each scan deflector may deflect the sub-beam in one direction (e.g., parallel to a single axis, such as an X axis) or in two directions (e.g., relative to two non-parallel axes, such as X and Y axes). The deflection may cause the sub-beam to be scanned across the sample 408 in the one or two directions (e.g., one dimensionally or two dimensionally). In an embodiment, the scanning deflectors described in International Application PCT/IB2010/051848 titled "CHARGED PARTICLE OPTICAL SYSTEM COMPRISING AN ELECTROSTATIC DEFLECTOR" filed on 28 April 2010, the contents of which is hereby incorporated in its entirety, specifically in relation to scan deflectors, may be used to implement the scan-deflector array. The scan-deflector array may be positioned between the objective lens array 410 and the control lens array 420. In the embodiment shown, the scan-deflector array is provided instead of the macro scan deflector 430. A scan-deflector array (e.g., formed using MEMS manufacturing techniques as mentioned above) may be more spatially compact than a macro scan deflector 430. The scan deflector array may be a passive scan director array, such as produced by MEMS manufacturing techniques, but not utilizing independent control or actuation of MEMS elements. For example, the scan deflector array may be an array of particle deflectors created in a single planar element. The planar element may be moved, which may generate deflection of the sub-beams by the array of particle deflectors causing scanning of the particle sub-beams across a surface of the sample 408. The movement of the planar element may be a macroscopic movement or otherwise not involve individual movement of the deflector elements, which, for example, may remain fixed in angle, orientation, position relative to the planar element, etc.

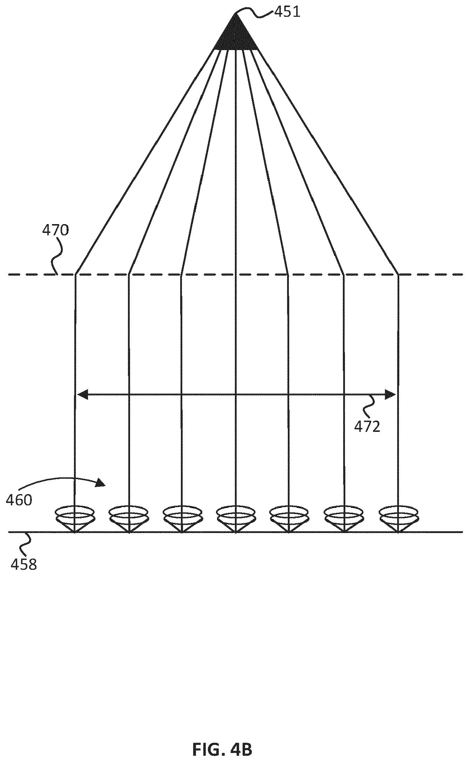

Figure 4B is a schematic diagram of an exemplary objective lens array assembly for a multi-beam apparatus in a multiple particle beam tool. The objective lens array assembly may be found within the multi-beam particle beam tool 340 of Figure 3. The objective lens array assembly may contain a particle source 451, which may be the particle source 350 of Figure 3 or any other appropriate particle source, or may receive a particle beam from any appropriate particle source, including one which may be outside of the objective lens array assembly. The objective lens array assembly is described in reference to a sample 458, which may be the sample 378 of Figure 3, such as supported by the sample holder 370 and the motorized stage 372 or any other appropriate support (including non-motorized support). The objective lens array assembly comprises planar elements defining a plurality of apertures aligned along paths of sub-beams of a primary particle beam produced by the particle source 451. The objective lens assembly array contains a collimator element array 470, which is an array of collimators. Each of the collimators may create a "beamlet" or sub-beam of the particle beam, such as through collimation, by deflection, etc. Each collimator of the collimator element array 470 may actively shape, focus, etc. a sub-beam, including by use of one or more lenses, focusing element, aperture, etc. The objective lens array assembly contains the collimator element array 470, instead of the macro collimator 440 as described in relation to Figure 4A. Although not shown, it is also possible to apply collimator element array 470 to an embodiment having a macro scan deflector and a collimator element array. Each collimator element of the collimator element array 470 collimates a respective sub-beam. The collimator element array 470 (which may be formed using MEMS manufacturing techniques) may be more spatially compact than a macro collimator 440 of Figure 4A. The collimator element array 470 may have a dimension 472, which may be approximately 15 mm with sub-beam separation of 70 $\mu$m. Providing the collimator element array 470 and a scan-deflector array together may therefore provide space saving and allow more sub-beams to be produced for the same surface area (e.g., of the sample 458). This space saving may be desirable where a plurality of sub-beams are produced, and may increase throughput in an inspection system through the use of increased sub-beam density. The movement of the collimator element of the collimator element array 470 may be actively controlled (e.g., individually controlled) or otherwise involve active activation of MEMS devices, such as individual activation of a deflector, individual control of a collimator voltage, etc. The use of active MEMS elements may further decrease the amount of area required for each sub-beam and thereby increase the areal density of the sub-beams on the sample 458.

The objective lens assembly array contains an objective lens array 460. The objective lens array 460 may be any appropriate array of objective lenses, such as the objective lens array 410 of Figure 4A. The objective lens array 460 may contain one or more control lens, including a control lens assembly. In one embodiment, a plurality of objective lens array assemblies may be provided. There may or may not be macro condenser lens or a condenser lens array in such a scenario, where a control lens may provide beam opening angle and magnification control for changes in landing energy. A beam shaping limiter may be provided down-beam of the control lens array. Apertures in the beam shaping limiter may adjust the beam current along the beam path so that control of the magnification by the control lens operates differently on the opening angle. That is the apertures in the beam shaping limiter may alter the expected direct correspondence between variations in the magnification and opening angle. In some embodiments, the collimator element array 470 is the first deflecting or focusing electron-optical array element in the beam path down-beam of the particle source 451.

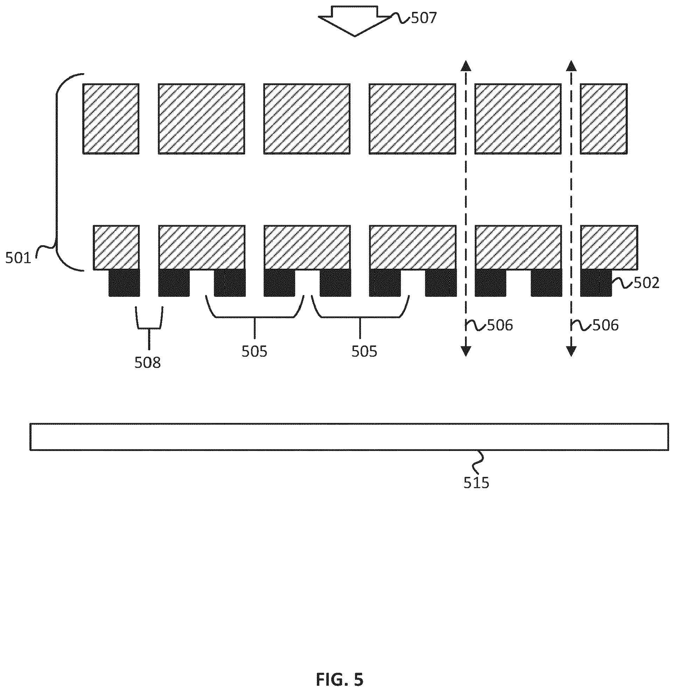

Figure 5 is a schematic side sectional view of a detector module integrated with a two-electrode objective lens array. Figure 5 shows a portion 501 of an objective lens array integrated with multiple detectors in schematic cross-section. In this embodiment, the detector comprises a detector module 502 comprising a plurality of detector elements 505 (e.g., sensor elements such as capture electrodes). In this embodiment, the detector module 502 is provided on an output side of the objective lens array of the portion 501. The output side is the side facing the sample 515. Beam apertures 508 allow for multiple particle beams, such as beamlets 506 or sub-beams, to pass through the objective lens array of the portion 501 (and through detector elements 505) from a particle source to the sample 515 along the direction indicated by arrow 507. Any appropriate objective lens arrangement may be used, such as those discussed in International Application PCT/EP/2021/080509 titled "OBJECTIVE LENS ARRAY ASSEMBLY, ELECTRON-OPTICAL SYSTEM, ELECTRON-OPTICAL SYSTEM ARRAY, METHOD OF FOCUSING" filed on 3 November 2021, the contents of which is hereby incorporated in its entirety.

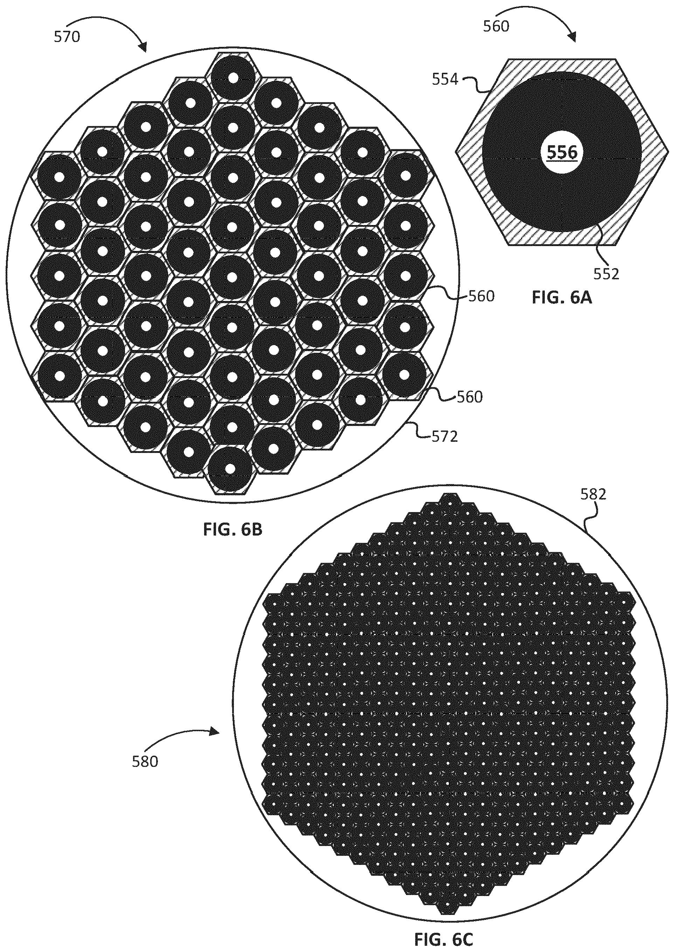

Figures 6A-6C are schematic diagrams of example particle detectors. Figure 6A is a plane view of a detector element 560, which may be the same as or different from the detector elements 505 of Figure 5. The detector element 560 may be an electron or other particle detector, including a charged particle detector, a photodiode, a photosensor, etc. The surface of the detector element 560 may contain areas which detect impinging particles, such as detector surface 552. The surface of the detector element 560 may also contain areas which do not detect impinging particles, such as detector surround 554. The detector surround 554 is depicted as corresponding to the detector element 560 itself, but may instead be a general detector surround 554 upon which the detector surfaces 552 are placed. The detector element 560 contains a beam aperture 556, which may permit transmission of the particle beam from the particle source to the sample. In one embodiment, the beam aperture 556 may also permit transmission of particles from the sample to another detector, such as located upstream of the detector element 560. The beam aperture 556 may be a window, e.g., may comprise one or more material substantially transparent to particles. The beam aperture 556 may be a void. The beam aperture 556 may be part of a beam aligner, focuser, collimator, etc. The size relationship between the detector surface 552 and the detector surround 554 is provided for example only, and the relative surface area of the detector surface may be larger or smaller. The detector surface 552 may be an electron detector. The detector surface 552 may detect BSEs, SEs, etc. The detector surface 552 may detect accumulated charge, such as during an integration time. The detector surface 552 may detect total charge, number of particles impinging, velocity of particles impinging, etc. The detector surface 552 or the detector surround 554 or another screening element may be used to prevent low energy particles (e.g., a retarding field may be used to prevent low energy electrons) from reaching the detector surface 552.

Figure 6B is a plane view of a particle detector 570. The particle detector 570 may be comprised of a plurality of detector elements 560 of Figure 6A. The particle detector 570 may be a global particle detector, comprised of a plurality of detectors (e.g., the detector elements 560). That is, either the particle detector 570 or the detector elements 560 may be thought of and referred to as "detectors". The particle detector 570 may be comprised of any other appropriate detector elements, such as rectangular detector elements, square detector elements, etc. The particle detector 570 is depicted having a close packing of detector elements 560. The particle detector 570 may instead have a linear or other arrangement of detector elements 560 or detector surfaces 552 on surface 572. The particle detector 570 may contain up 1,800 detector elements 560. The particle detector 570 may contain up to 30,000 detector elements 560. The particle detector 570 may be part of an objective lens, such as comprising a sample-side surface of an objective lens. The particle detector 570 may have areas which are not covered by detector elements 560, such as edge areas, a central beam area, etc. The particle detector 570 may be a BSE electron detector, a SE electron detector, etc. The particle detector 570 may comprise detector elements 560 which are substantially similar (e.g., as depicted) or which vary, such as based on location. The detector elements 560 of the particle detector 570 may vary in size, separation, orientation (e.g., along an out of plane angle) across the surface of the particle detector 570. For example, the detector elements 560 may be closer near the center of the particle detector 570 and have larger separation near the edge of the particle detector 570.

The detector elements 560 may be angled, size, oriented, etc. to present an equal or unequal detector surface (such as the detector surface 552) to incident particles. The particle detector 570 is depicted as having a substantially two-dimensional surface, such as facing the sample. The particle detector 570 may be substantially planar. In one embodiment, the particle detector 570 may be curved of otherwise non-planar. The detector elements 560 may be angled, transformed, rotated, etc. so that the detector elements 560 have substantially similar projections along planes perpendicular to the parallel beams of the particle beam tool. The particle detector 570 may have different type of detectors, such as detector elements 560 which detect electric charge and detector elements 560 which detect electron energy.

Figure 6C is a plane view of a particle detector 580. The particle detector 580 may be comprised of detector elements 560 of Figure 6A. The particle detector 580 may have any of the attributes previously described for the particle detector 570. The particle detector 580 may have a surface 582. The particle detector 580 is provided as an example of the particle detector with more detector elements than the particle detector 570. It should be understood that a particle detector may have even more detector elements than depicted, for either the particle detector 570 or the particle detector 580, including massively parallel detector elements (-1800, -30,000, or the like of detector elements), or fewer detector elements and depicted.

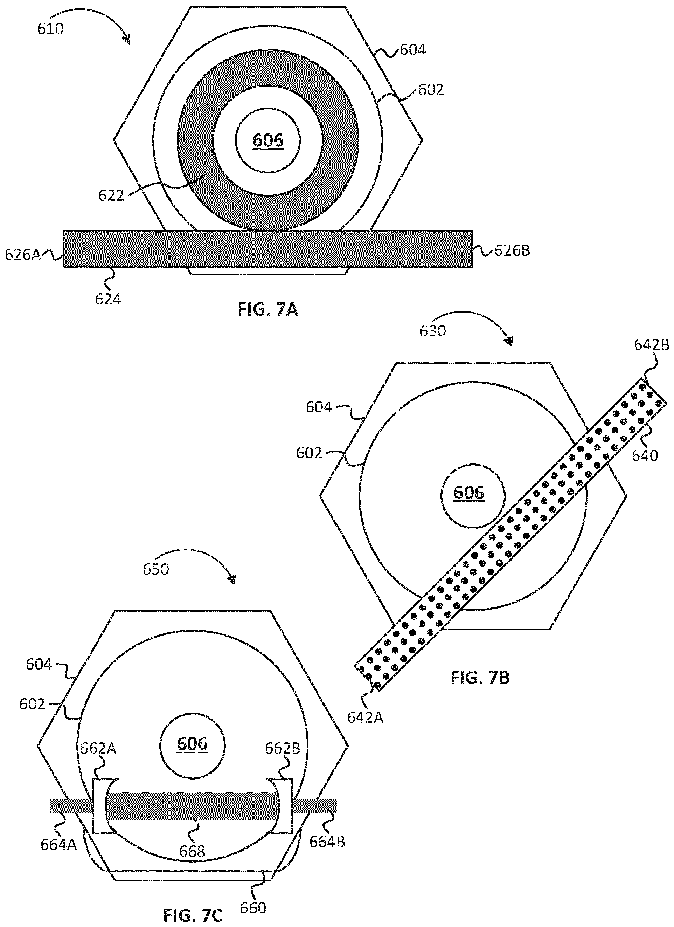

Figures 7A-7C are schematic diagrams of example optical resonators associated with particle detectors. Figures 7A-7C are plane views of example optical resonators, depicted as located on the backsides of detector elements, wherein the backside corresponds to a face of a detector element not facing the sample or otherwise not exposed to incident particles. The optical resonators may instead be located on the front side of detector elements (such as in locations shielded from incident particles), on the sides of detector elements (such as between detector elements), integrated into one or more layers of the detector elements (such as within fabrication layers of the two detector elements), etc. Each of the resonators may be associated with a detector. As there may be a plurality of detectors, there may be a plurality of resonators, where each of the plurality of detectors may be associated with one of the resonators. This does not require that each and every detector of the plurality of resonators is associated with exactly one resonator of the plurality of resonators-in some cases a detector may be associated with no resonators, more than one resonator, etc. and in other cases a resonator may be associate with no detector, more than one detector, etc. There may be additional detectors or additional resonators within an apparatus or system, which may fall outside the relationships described here. The optical resonators may be connected, such as electrically, optically, etc., with the detector elements. The optical resonators may be connected with one or more signal processing elements, including amplifiers, rectifiers, clocking element, reset elements, storage elements, memory elements, integration elements, logical elements, etc. The optical resonators may be connected in series with one or more signal processing elements which are connected with the detector elements. In Figures 7A - 7C, optical resonators are depicted as connecting to the backside of detector elements, but it should be understood that there may be intervening elements which are not depicted. Herein "optical resonators" is used to encompass electromagnetic resonators. The use of this term does not limit such optical resonators to visible or optical wavelengths, although the resonators described herein may operate in optical or visible wavelength ranges. The optical resonators may be tuned to a resonance wavelength or frequency. As frequency and wavelength are related, any use herein of "wavelength" or "frequency" should be understood to encompass the alternative, such as with appropriate conversion relationships.

The optical resonators may be connected to the detector elements by modulators. The modulator may alter (e.g., change) a resonance wavelength of the optical resonator to which it is connected. The modulator may alter the resonance wavelength by altering a refractive index (such as of an optical ring resonator), a size, a dielectric, etc. The modulator may operate via thermal effects, the free carrier effect, depletion region effects, etc. The modulator may receive an input signal from a detector element associated with the optical resonator. The modulator may alter a wavelength of light, such as in amplitude or frequency-and in such an example, the modulator may operate with or without an optical resonator. The modulator may receive input from an amplification stage, which received input from a detector element. The modulator may receive a drive voltage or other source of power, which may provide power input to the amplification stage. The modulator may be an electro-optic transducer.

The modulator may alter characteristics of the resonance wavelength as a function of an output of a detector element. For example, the detector element may output a signal which contains information about the amount of charge accumulated on the detector element (which may roughly correspond to the number of charged particles incident on the detector element). The output signal strength, offset, etc. may correspond, including linearly, to the amount of accumulated charge. The output signal strength, offset, etc. may correspond, including a binary manner, to whether or not particles were detected. The output signal strength, offset, etc. may encode additional information, such as information about the accumulation time, total charge, electron energy, etc. encoded, such as along a carrier signal, in a digital or analog manner. The modulator may then alter characteristics of the resonator based on the output signal of the detector element. The characteristics of the resonator may be altered such that they correspond, including linearly, to a quantity measured by the detector element. The characteristics of the resonator may be altered (e.g., by the detector) which may result in a change or alteration of a phase, wavelength, amplitude, etc. of an electromagnetic wave (e.g., light) which interacts (e.g., is incident to, travels along, etc.) with the resonator. The characteristics of the resonator may be measured with respect to a base characteristic, such as an input phase, a resonance wavelength, and input amplitude, etc. of the wave interacting with (e.g., incident on) the resonator. The modulator may itself have low capacitance (e.g., lower-than-expected for amplification element) which may mean that the energy required for modulation is on the order of femto-Joules. The modulator may have lower energy requirements than a corresponding amplifier (e.g., the amplifier may have a larger energy draw than a modulator, including a modulator which receives a signal output by the amplifier). The modulator may produce relatively little heat, such as a small enough amount of heat that active heat transfer or dissipation is not required.

Figure 7A is a plan view of an optical ring resonator 622 associated with detector element 610. The backside of the detector element 610 is depicted, which includes detector surface 602, detector surround 604, and beam aperture 606. The detector surface 602 may or may not be present on the backside of the detector element 610. For example, the detector surface 602 may correspond to an outline of where the detector surface 602 would appear on the backside of the detector element 610 if the detector surface 602 extended through the detector element 610 to its backside. The detector surface 602 may be any appropriate detector surface, such as previously described in relation to the detector surface 552 of Figure 6A. The detector surround 604 may be the same as the detector surround 554 previously described in relation to the detector surround 554 of Figure 6A. The detector surround 604 may instead be different material, such as a structural support, and makes up the detector surround 554. The beam aperture 606 may be any appropriate beam aperture, such as previously described in relation to beam aperture 556 of Figure 6A. The detector element 610 may have a non-negligible thickness, such as in the out of plane direction. The detector element 610 may be heterogeneously or homogeneously integrated circuit. The detector element 610 may comprise silicon CMOS devices.

The optical ring resonator 622 may be a ring resonator, a disk resonator (such as of a material transparent to charged particles), a whispering gallery resonator or operating in whispering gallery mode (WGM), or any other ring resonator structure. The optical ring resonator 622 may be symmetric (e.g., substantially round). In one embodiment, the optical ring resonator 622 may have an asymmetric (e.g., radially) or otherwise not round shape in a plane view. For example, the optical ring resonator 622 may be a racetrack resonator or any other appropriate shape. The optical ring resonator 622 may present a parallelogram in cross-section (for example, be substantially rectangular in cross-section). In one embodiment, the optical ring resonator 622 may have angled sidewalls. In one embodiment, the optical ring resonator 622 may have curved sidewalls. The optical ring resonator 622 may be constructed in a conductive material, such as of a metal, in a nonconductive material, such as in quartz, or in a semiconductor. The optical ring resonator 622 may have a bandgap (or energy bands) such that the optical ring resonator 622 is substantially transparent to optical wavelengths near the resonance wavelength. The optical ring resonator 622 may be comprised of multiple materials or multiple resonators, such as optically coupled double ring resonators (e.g., optical ring resonator mirrors), or any other appropriate structures.

The detector element 610 may be optically interrogated (e.g., probed, a response solicited, interacted, etc.) via a waveguide 624. The waveguide 624 may supply an input wavelength or wavelengths to the optical ring resonator 622, where the optical ring resonator 622 is modulated based on signals corresponding to particles incident on the detector surface 602. The waveguide 624 may be constructed of the same or different material as the optical ring resonator 622. The waveguide 624 may be an optical fiber, including where the optical ring resonator is a CMOS device. The waveguide 624 may be a single mode, multi-mode, polarization-maintaining, jacketed, unjacketed, or any other appropriate type of optical fiber. The waveguide 624 may contain reflectors, such as distributed Bragg reflectors (DBRs), or any other appropriate fixed or variable reflectors. The waveguide 624 may receive input light from one direction, such as input 626A, and produce output light from an opposite direction, such as output 626B. In one embodiment, the waveguide 624 may instead or additionally receive input light from one direction, such as the input 626A, and produce output light (such as via reflection) in the same direction. In such a case, the output 626B may be negligible (e.g., if substantially all light is reflected), may be non-signal carrying light (e.g., if only resonance wavelengths are reflected), etc. The output 626B may contain one or more non-reflective termination elements. The waveguide 624 may be connected to multiple optical ring resonators, in addition to the optical ring resonator 622, including optical ring resonators corresponding to other detector elements than detector element 610.

The waveguide 624 may be in-plane with the optical ring resonator 622 or may be offset vertically (e.g., out of the plane as depicted) from the optical ring resonator 622. The waveguide 624 may be continuous (e.g., touch) the optical ring resonator 622. The waveguide 624 may alternatively be separated from the optical ring resonator 622 by a separation distance, where the separation distance is smaller than an optical coupling distance of the optical ring resonator 622 and the waveguide 624. The waveguide 624 may terminate at or near the optical ring resonator 622 or may continue in either direction passed the optical ring resonator 622. The waveguide 624 may instead be multiple waveguides, including an input waveguide and an output waveguide, or any other appropriate configuration of waveguides.

Figure 7B is a plan view of a photonic crystal 640 associated with detector element 630. The detector element 630 may be any appropriate detector element, such as the detector element 610 previously described in relation to Figure 7A. The detector element 630 is depicted in a backside view, where the detector surface 602, detector surround 604, and beam aperture 606 are visible as projections from the detector element 630 frontside.

The photonic crystal 640 may be a photonic crystal resonator, such as a photonic crystal that functions as a resonator. The photonic crystal 640 may be photonic crystal filter, which permits transmission of some wavelengths of input light. The photonic crystal 640 may be a one-dimensional (or quasi-one-dimensional) photonic crystal, a two-dimensional photonic crystal, a three-dimensional photonic crystal, etc. The photonic crystal 640 may be a photonic crystal nanocavity. The photonic crystal 640 may be integrated into a waveguide, such as a photonic crystal waveguide. The photonic crystal 640 may be contacted by an input light source, such as a waveguide. The waveguide (or other optical source) may be integrated into the photonic crystal 640, optically connected, or otherwise able to supply light to the photonic crystal 640. The photonic crystal 640 may be interrogated by the input light, and may output a corresponding signal in the same or a different direction. The photonic crystal 640 may receive input light from an input 642A and transmit light via an output 642B. The photonic crystal 640 is depicted having a linear shape, but may be any appropriate shape, including round, elliptical, oblong, etc. A resonance wavelength of the photonic crystal 640 may be altered by a modulator of the detector element 630. The modulator may be any appropriate modulator, such as previously described. The modulator may alter physical, electrical, chemical, etc. characteristics of the photonic crystal 640 and thereby alter one or more resonance wavelengths of the photonic crystal 640.

Figure 7C is a plan view of a linear resonator 660 associated with detector element 650. The detector element 650 may be any appropriate detector element, such as the detector element 610 or 630 previously described in relation to Figure 7A and Figure 7B. The detector element 650 is depicted in a backside view, where the detector surface 602, detector surround 604, and beam aperture 606 are visible as projections from the detector element 650 frontside.

The linear resonator 660 may be a resonator cavity 668. The linear resonator 660 comprises one or more reflector (e.g., reflectors 662A and 662B), along with the resonator cavity 668 between the reflectors 662A and 662B. Two reflectors 662A and 662B are depicted, but three or more reflectors may be used. A single resonator cavity 668 is depicted, but two or more resonator cavities, including in series, in parallel, etc., may be used. The reflectors 662A and 662B may be integrated reflectors, such as integrated into a waveguide or other optical material. The linear resonator 660 may be a standing wave resonator, or any other appropriate linear resonator. The linear resonator 660 may have any appropriate reflectors, including concentric reflectors, confocal reflectors, etc. The reflectors 662A and 662B may be integrated into a waveguide, such as DBR in line in an optical fiber. The reflectors 662A and 662B may be quasi-permeable (e.g., not 100% reflective). The linear resonator 660 may be a quasi-linear resonator (e.g., may have a non-negligible vector in an out of line direction). The linear resonator 660 may have an input 664A, such as through the reflector 662A, and an output 664B, such as occurring through-such as through an aperture or a quasi-permeable region of-the reflector 662B. The linear resonator 660 may be any appropriate linear resonator. The linear resonator 660 may be integrated within the area of the detector element 650, or may occupy space across two or more detector elements. A resonance wavelength of the linear resonator 660 may be altered by a modulator of the detector element 650. The modulator may be any appropriate modulator, such as previously described. The modulator may alter physical (e.g., length), electrical (e.g., dielectric), chemical (e.g., atomic polarization), etc. characteristics of the linear resonator 660 and thereby alter one or more resonance wavelengths of the linear resonator 660. The modulator may alter characteristics of one or more of the reflectors 662A and 662B or of the resonator cavity 668.

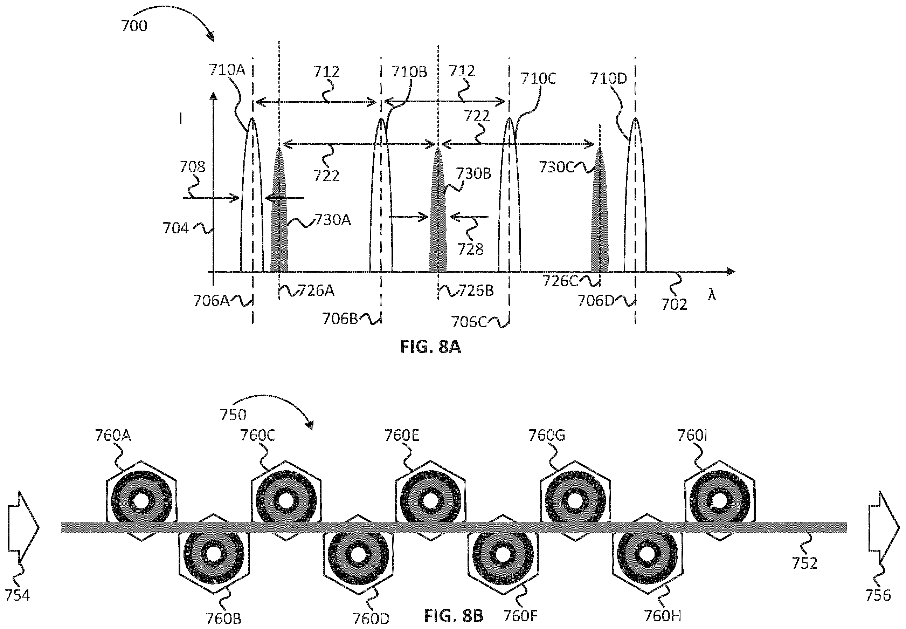

Figures 8A-8B are schematic diagrams of relationships between multiple resonators. Figure 8A is a graph 700 which illustrates, as a function of wavelength along the x-axis 702 and intensity along the y-axis 704, a relationship between resonance wavelengths for two resonators, which may be optical ring resonators, linear resonators, photonic crystal nanocavities, etc. A first resonator has resonance peaks 710A-710D, while a second resonator has resonance peaks 730A-730C, in the wavelength range depicted along the x-axis 702. Resonance peaks, which may correspond to transmitted light from the resonators, may instead be resonance valleys, which may correspond to destructively interfered, scattered, absorbed, refracted, etc. by the resonators near the resonance wavelength. Each resonance peak may correspond to a resonance wavelength (e.g., resonance wavelengths 706A-706D for resonance peaks 710A-710D and resonance wavelengths 726A-726C for resonance peaks 730A-730C), which may be a central wavelength, a most intense wavelength, etc. The shape of the resonance peaks may vary based on the type of resonator, the type of interrogator (e.g., the type of input wavelength), the measurement device, etc. The shape of the resonance peaks may be Gaussian, Lorentzian, etc. The resonance wavelengths 706A-706D for resonance peaks 710A-710D and the resonance wavelengths 726A-726C for resonance peaks 730A-730C may be identified by curve fitting, including by curve fitting in frequency space, based on transforms (such as Fast Fourier Transforms (FFTs)), etc.

Resonators, including optical resonators, may have multiple resonance wavelengths. For example, ring resonators may resonate at specific wavelengths (or frequencies), such as those which satisfy Equation 1, for an optical path length difference (OPD), below:

$$\lambda_m = \frac{2\pi r * n_{eff}}{m} \qquad (1)$$

where r is the radius of the ring resonator, $n_{eff}$ is the effective index of refraction, m is an integer representing the number of integer multiples of the wavelength which occur around the optical path (e.g., the circumference), and $\lambda_m$ is the resonance wavelength corresponding to the mode m. For optical waveguides supplying input light of multiple wavelengths, e.g., $\lambda_m$ with wavelengths between -250 nm and 5 μm(using 1550 nm as an example wavelength), a radius of approximately 40 μm, $n_{eff}$ corresponding to silicon in air (e.g., 3.88), and the resonance wavelengths may correspond to approximately modes near m--630. The number of excited modes may depend on the bandwidth of input light, drift over time of the wavelength of the input light, measurement time, etc. A free spectral range (FSR) is the difference between resonant modes of the resonator, The FSR may vary based on the resonator size, resonator material, input wavelength, etc. and may be $\Delta\lambda \sim 4$ nm. The separation between the resonant peaks (e.g., the resonant modes of the resonator) may vary based on the mode number (e.g., based on wavelength), but for large mode numbers FSR may be considered substantially constant within adjacent modes (e.g., for modes of $m\pm10$).

The first resonator has FSR 712, given by the difference between resonance wavelengths 706A and 706B, between the resonance wavelengths 706B and 706C, etc. which may be substantially equal over the wavelength range depicted in the graph 700. The second resonator has FSR 722, given by the difference between the resonance wavelengths 726A and 726C and between the resonance wavelengths 726B and 726C, etc. which, as described for the first resonator, may be substantially equal over the wavelength range depicted in the graph 700. The resonance peaks 710A-710D of the first resonator may have a linewidth 708. The resonance peaks 730A-730C may have a linewidth 728. The linewidth may be measured based on a curve fitting of the resonance peak or experimentally, such as as a full-width half-max (FWHM). The linewidth for the resonance peak may be dependent on the Q factor of the resonator, such as by the relationship given in Equation 2, below:

$$Q = \frac{f_r}{\Delta f} = \frac{\omega_r}{\Delta \omega} = \frac{\lambda_r}{\Delta \lambda} \qquad (2)$$

Where Q is the dimensionless quality factor, $f_r$ is the resonance frequency, $\Delta f$ is the linewidth in frequency, $\omega_r$ is the resonance angular frequency, $\Delta\omega$ is the linewidth in angular frequency, $\lambda_r$ is the resonance wavelength, and $\Delta\lambda$ is the linewidth in wavelengths. If a resonator has a Q value of $10^6$, and a resonance wavelength near 1550 nm, then the linewidth of the resonance peaks is expected to be about 1.5 pm. Linewidth may be independent for the size of the resonator, but may depend upon fabrication and material quality. The FSR may depend on the size of a resonator. In an example, for a ring resonator with radius of 40 μm (e.g., which has a circumference of -250 μm), the FSR may be determined using Equation 3, below:

$$FSR = \frac{\lambda_0^2}{n_g L} \qquad (3)$$

Where $\lambda_0$ is the resonance wavelength, $n_g$ is the group index of the resonator material, and L is the circumference of the resonator (or length for linear resonators). For the 40 μm ring resonator, this gives a FSR of approximately 4 nm. For a FSR of 4 nm and a linewidth of 1.5 pm, approximately 2666 parallel optical channels may be resolvable which means that approximately 2666 detector elements may be interrogated using one optical interrogation line. In application, fewer parallel optical channels may be resolvable. For example, if the Q factor is $10^5$ and the resonator radius -40 μm, the linewidth may be 14 pm and the FSR may be 3.82 nm. This may reduce the available parallel channels which can be individually resolved for readout to approximately -300 channels, or roughly 300 detector elements which may be interrogated.

Figure 8B is a plane view of a branch 750 of an optical multiplexer. The branch has a set of multiple resonators 760A-760I optically connected to a waveguide 752. The waveguide 752 may receive input light from a direction 754 and output light to a direction 756. Alternatively or instead, the waveguide 752 may output light to the direction 754. The light input to the waveguide 752 may interact with one or more of the multiple resonators 760A-760I. The multiple resonators 760A-760I are depicted as ring resonators, but it should be understood that they may instead or additional be linear resonators, photonic crystals, etc. The multiple resonators 760A-760I may have individual characteristics, such as ring resonator radius, ring resonator material, individual refractive index, etc., which may lead the multiple ring resonators 760A-760I to have individual resonance wavelengths (or resonance peaks).

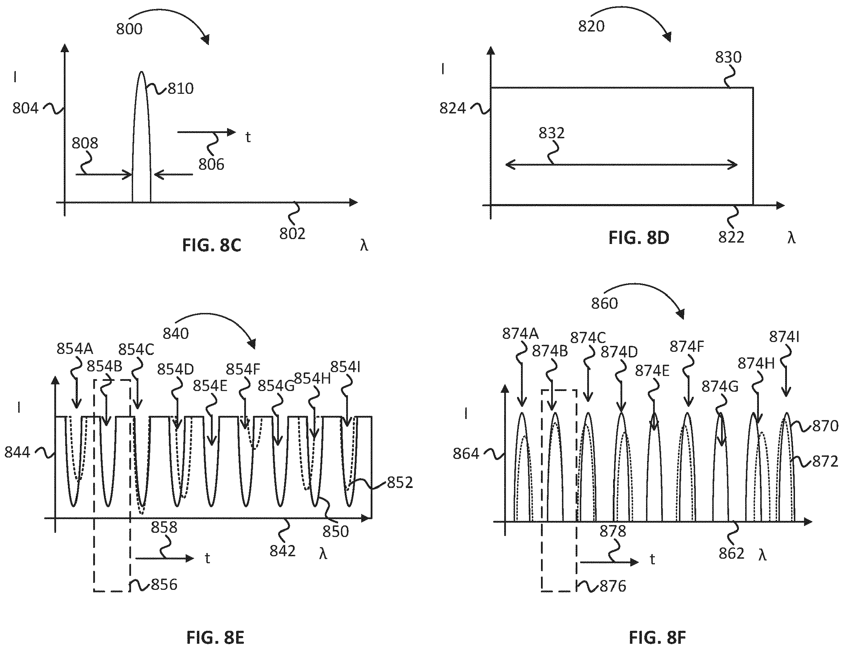

Figure 8C is a graph 800 which illustrates, as a function of wavelength along the x-axis 802 and intensity along the y-axis 804, an example input signal for interrogation of one or more resonators, which may be optical ring resonators, linear resonators, photonic crystal nanocavities, etc. A peak 810, with linewidth 808, represents an interrogation wavelength which may be input into the one or more resonators. The peak 810 may be scanned in wavelength as a function of time in the direction 806 (or antiparallel to the direction 806). The peak 810 may be a laser peak, such as produced by any appropriate laser source. The peak 810 may have a smaller linewidth than expected for the resonators, such that the resolution of the resonator resonance linewidth is a function (e.g., convolution) of substantially only the resonator Q factor. In one embodiment, the peak 810 may instead be multiple peaks, such as from two or more multiplexed sources.

Figure 8D is a graph 820 which illustrates, as a function of wavelength along the x-axis 822 and intensity along the y-axis 824, an example broadband input signal for interrogation of one or more resonators, which may be optical ring resonators, linear resonators, photonic crystal nanocavities, etc. An intensity 830 is produced for a range of wavelengths 832. The range of wavelengths 832 may correspond to one or more FSR of the one or more optical wavelengths. The intensity 830 may be substantially constant over the range of wavelengths, vary over the wavelengths, etc.

Figure 8E is a graph 840 which illustrates, as a function of wavelength along the x-axis 842 and intensity along the y-axis 844, an example output signal 850 (solid line) after interrogation of one or more resonators, where the resonators scatter resonance wavelengths. The one or more resonators may be optical ring resonators, linear resonators, photonic crystal nanocavities, etc. The one or more resonators may selectively pick up optical signals corresponding to resonance peaks, thereby removing such resonance peaks from transmitted light. The one or more resonators may also or instead transmit the optical signals corresponding to the resonance peaks to another output waveguide, to an optical sink, etc. Each of the plurality of resonators may have (e.g., be tuned to) an individual resonance wavelength, where each of the resonance wavelengths may be different from all other resonance wavelengths. In the example output signal 850, this is shown where absorption peaks 854A-854I are non-overlapping. In one embodiment, the absorption peaks 854A-854I may be overlapping, but resolvable such as through peak fitting. The example output signal 850 may correspond to interrogation of the one or more resonators when the detector elements (to which they correspond) are not active. That is, the example output signal 850 may correspond to interrogation of the one or more resonators (e.g., the multiple resonators 760A-760I of Figure 8B) where the detector elements detect no particles or otherwise emit no output signals to the corresponding modulators. The absorption (where absorption may indicate only an absence of transmission or opacity at a given wavelength) peaks 854A-854I may each correspond to one of the multiple resonators 760A-760I of Figure 8B. An example detection signal 852 (dashed line) may correspond to interrogation of the one or more resonators when at least some of the detector elements (to which they correspond) are active. That is, the example detection signal 852 may correspond to interrogation of the one or more resonators (e.g., the multiple resonators 760A-760I of Figure 8B) where at least some of the detector elements detect particles and emit signals to the corresponding modulators, which alter resonance characteristics of some of the one or more resonators. The offset (e.g., in wavelength or intensity) of the absorption peaks 854A-854I in the example output signal 850 and in the example detection signal 852 may encode the output signals of the various detector elements (such as of the multiple resonators 760A-760I of Figure 8B). The offset in wavelength and the offset in intensity may be related, as resonator intensity may fall in intensity as modulation is applied to alter the resonance wavelength.

The example output signal 850 or the example detection signal 852 may be detected by scanning across a wavelength range, by a detector or a source. If the source is a narrow linewidth source, such as depicted in the graph 800 of Figure 8C, the detector may detect the example output signal 850 or the example detection signal 852 based on intensity without respect to wavelength. If the source is a broadband source, such as depicted in the graph 820 of Figure 8D, the detector may detect the example output signal 850 or the example detection signal 852 by sweeping a wavelength range window (e.g., the range window 856) across a range of wavelengths as a function of time. The example output signal 850 or the example detection signal 852 may be detected in intensity and correlated to wavelength based on information about the sweeping of the optical source wavelength or detector range.

Figure 8F is a graph 860 which illustrates, as a function of wavelength along the x-axis 862 and intensity along the y-axis 864, an example output signal 870 after interrogation of one or more resonators, where the resonators emit resonance wavelengths. The one or more resonators may be optical ring resonators, linear resonators, photonic crystal nanocavities, etc. The one or more resonators may selectively pick up optical signals corresponding to resonance peaks, such as from a waveguide, and transmit the optical signals corresponding to the resonance peaks to another or the same waveguide. The one or more resonators may also or instead block or not transmit the optical signals which do not correspond to the resonance peaks. The example output signal 870 (solid line) may correspond to interrogation of the one or more resonators when the detector elements (to which they correspond) are not active. That is, the example output signal 870 may correspond to interrogation of the one or more resonators (e.g., the multiple resonators 760A-760I of Figure 8B) where the detector elements detect no particles or otherwise emit no output signals to the corresponding modulators. The transmission (where transmission may indicate transparency at a given wavelength) peaks 874A-874I may each correspond to one of the multiple resonators 760A-760I of Figure 8B. An example detection signal 872 (dotted line) may correspond to interrogation of the one or more resonators when at least some of the detector elements (to which they correspond) are active. That is, the example detection signal 872 may correspond to interrogation of the one or more resonators (e.g., the multiple resonators 760A-760I of Figure 8B) where at least some of the detector elements detect particles and emit signals to the corresponding modulators, which alter resonance characteristics of some of the one or more resonators. The offset (e.g., in wavelength or intensity) of the absorption peaks 874A-874I in the example output signal 870 and in the example detection signal 872 may encode the output signals of the various detector elements (such as of the multiple resonators 760A-760I of Figure 8B). The offset in wavelength and the offset in intensity may be related, as resonator intensity may fall in intensity as modulation is applied to alter the resonance wavelength. The intensity of the transmitted signal may be limited by the strength of the input optical signal.

The example output signal 870 or the example detection signal 872 may be detected by scanning across a wavelength range, by a detector or a source. If the source is a narrow linewidth source, such as depicted in the graph 800 of Figure 8C, the detector may detect the example output signal 870 of the example detection signal 872 based on intensity without respect to wavelength. If the source is a broadband source, such as depicted in the graph 820 of Figure 8D, the detector may detect the example output signal 870 or the example detection signal 872 by sweeping a wavelength range window (e.g., the range window 876) across a range of wavelengths as a function of time. The example output signal 870 or the example detection signal 872 may be detected in intensity and correlated to wavelength based on information about the sweeping of the optical source wavelength or detector range.

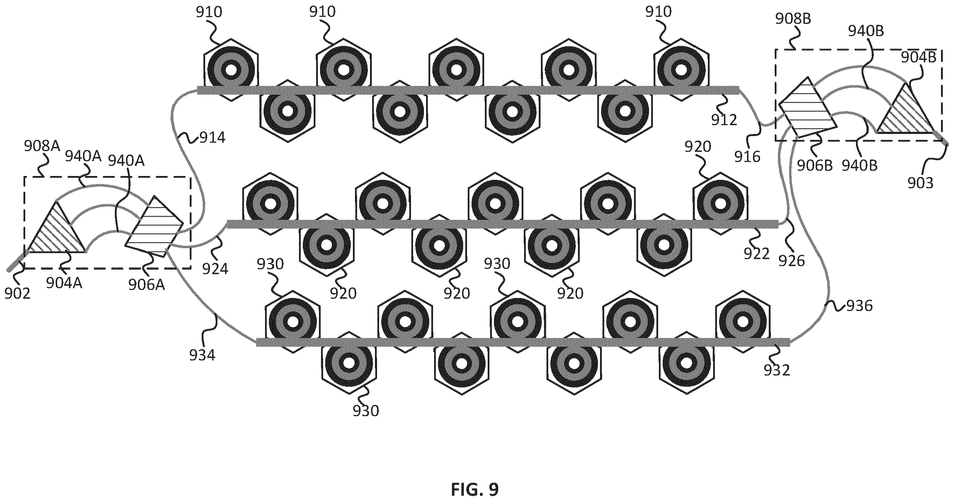

Figure 9 is a schematic diagram of multiple resonators on multiple waveguides. Figure 9 is a plane view of branches of an optical multiplexer with multiple waveguides. A first branch contains detector elements 910 along waveguide 912, a second branch contains detector elements 920 along waveguides 922, and a third branch contains detector elements 930 along waveguide 932. The depicted detector elements and waveguides are provided as examples, and more (e.g., up to 300 detector elements per waveguide) or fewer detector elements may be provided per waveguide, and more (e.g., up to 10 or more waveguides) or fewer waveguides may be provided. The waveguides 912, 922, and 932 may be interrogated by an optical source (e.g., via an input 902) which may be split into multiple input signals each having a different bandwidth. The multiple input signals may each have a bandwidth corresponding to the FSR of the multiple detector elements, for example of approximately 4 nm. The multiple input signals may interrogate different resonance wavelengths (e.g., different FSRs) for each of the branches of the optical multiplexer. The input 902 is connected to an arrayed waveguide grating (AWG) 908A or other optical splitting element may be used to supply each of the waveguides 912, 922, and 932 with the multiple input signals.

The AWG 908A contains a free space 904A, where light from the input 902 propagates, from which the light enters a set of optical fibers 940A each having a different length and therefore applying a different phase shift. The light from the optical fibers then traverses another free space 906A, where the light with different phases constructively and destructively interferes, to produce light of wavelength range at various output locations connected to optical fibers 914, 924, and 934. The AWG 908A may supply each branch of the optical multiplexer with a limited bandwidth of light, such as if the input 902 receives a broadband or multiple peak input optical signal.

The multiple branches of the optical multiplexer may be interrogated by corresponding multiple input signals, and may output corresponding multiple output signals. The multiple output signals may be multiplexed by the AWG 908B or another appropriate element. The AWG 908B may operate in reverse of the AWG 908A, where the multiple output signals are received at a free space 906B, for example from optical fibers 916, 926, 936, where the multiple output signals interfere constructively and destructively and are output to multiple optical fibers 940B with different path. The multiple optical fibers 940B supply the light to another free space 904B where the light propagates to an output 903, which may be optically connected to one or more optical detector.

The AWG 908A and 908B may be the same or different splitting elements. The detector elements 910, 920, 930 may be the same or different detector elements. The waveguides 912, 922, 932 may be the same or different waveguide materials. The waveguides 912, 922, 932 are depicted as linear waveguides, but can instead be curved waveguides, such that the detector elements 910, 920, 930 may be arranged along multiple beam paths of a particle beam apparatus, such as linearly, by close packing, etc. The multiple branches of the optical multiplexer may be used to interrogate up to 10 or more separate bandwidths (for example, corresponding to increments in bandwidth substantially equal to the FSR of the detector elements). The optical multiplexer may interrogate up to --3000 detector elements (e.g., 300 detector elements per waveguide with 10 waveguides) or more. Multiple optical multiplexers may be used to interrogate up to -1,800 or -30, 000 detector elements, such as substantially all detector elements of a particle detector. The optical multiplexer may be used with a narrow band, multiple peaks, broadband, etc. optical source.

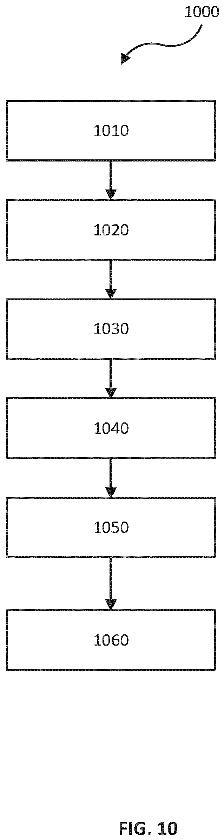

Figure 10 is a flowchart which illustrates a method of detecting multiple particle beams. Each of these operations is described in detail below. The operations of method 1000 presented below are intended to be illustrative. In some embodiments, method 1000 may be accomplished with one or more additional operations not described, and/or without one or more of the operations discussed. Additionally, the order in which the operations of method 1000 are illustrated in Figure 10 and described below is not intended to be limiting. In some embodiments, one or more portions of method 1000 may be implemented (e.g., by simulation, modeling, etc.) in one or more processing devices (e.g., one or more processors). The one or more processing devices may include one or more devices executing some or all of the operations of method 1000 in response to instructions stored electronically on an electronic storage medium. The one or more processing devices may include one or more devices configured through hardware, firmware, and/or software to be specifically designed for execution of one or more of the operations of method 1000, for example.

At an operation 1010, signals corresponding to a received media are detected. The received media may be one or more particles, which may be charged particles. The signals may be charged signals (e.g., an amount of charge accumulated during an accumulation time). The signals may be acquired over time (e.g., as a particle impinges on a detector surface) or may be measured at measurements times, such as after an accumulation time has passed since a reset signal. The signals may be analog signals or digital signals. The signals may be quantized, such as to correspond to a number of particles detected (e.g., 2, 100, etc.). The signals may be an accumulated charge or a voltage that corresponds to an accumulated charge. The signals may be detected by detector elements, such as those previously described herein. The signals may be amplified, such as by one or more amplification element. The signals may be processed, such as smoothed, averaged, thresholding applied, etc. A signal corresponding to no received media (e.g., a null signal) may also be detected. A first null signal type may correspond to an active detector which received no received media, such as during an accumulation time. A second null signal type may correspond to an inactive detector.

The received media may correspond to particles reflected by a sample. The received media may correspond to particles reflected by the sample, where the particles impinging on the sample previously passed through a given detector element (e.g., corresponding to a beam of the multiple beams which occupied a beam aperture in the detector element). The received media may correspond to particles reflected by the sample where the particles impinging on the sample previously passed through a detector element other than the given detector element (e.g., corresponding to a beam of the multiple beams which does not occupy the beam aperture in the given detector element). The detector elements may acquire information about the received media, such as electron energy, angle, type of electron (e.g., BSE, SE, etc.), in addition to or instead of information about the amount of received media (e.g., number of electrons).

At an operation 1020, the detected signals are applied to a plurality of resonators. The detected signals may be applied, in a one-to-one correspondence, in a multiple-to-one correspondence, etc., to a resonator of the plurality of resonators. The detected signals may be applied to the plurality of resonators by a plurality of modulators, where the modulators may correspond to the detectors and the resonators in a one-to-one correspondence, in a multiple-to-one correspondence, etc. The modulators may be any appropriate resonance modulator, such as previously described. The modulators may be electro-optic modulators. The modulators may alter an optical path length of a corresponding resonator. Each modulator, such as in response to a signal or other output of a detector, or each detector, such as through action of a modulator, may be configured to change an optical path length of a resonator associated with the modulator, detector, or both. The modulators may alter the refractive index of a corresponding resonator. Each modulator, such as in response to a signal or other output of a detector, or each detector, such as through action of a modulator, may be configured to change a refractive index of a resonator associated with the modulator, detector, or both. The modulators may alter the resonator physically, electrically, chemically, etc. The modulators may encode information from the detected signals, for example digitally. Each of the plurality of resonators may be tuned to an individual resonance wavelength different from resonance wavelengths of other resonators. That is, each of the resonators may be identifiable based on its resonance wavelength, e.g., from optical output.

Detecting the signals corresponding to the received media may include modulating, by a plurality of modulators, the detected signals and applying the detected signals to the plurality of resonators may include applying, by the plurality of modulators, the modulated signals to the plurality of resonators. The modulation of the signals may occur, including at the operation 1010 or the operation 1020, at the plurality of resonators.

At an operation 1030, an optical input is supplied to the plurality of resonators. The optical input may be supplied by a waveguide. The waveguide may be an optical waveguide, may be an optical fiber, may be a photonic crystal, etc. The waveguide may be any appropriate material as previously described. The optical input may be a narrow band input (e.g., a laser input, including sources where a source linewidth may be in the 100 kHz range), including a narrow band input of multiple peaks (e.g., multiple laser input). The optical input may be considered a narrow band input where the linewidth of the optical input is significantly narrower than an output (e.g., resonance peak) of a resonator, such that the output peak experiences substantially no broadening (for example, due to convolution) due to the optical input. The optical input may be a broadband input (e.g., white light, telecommunication source input, etc.). The optical input may be multiplexed, such as using an AWG, to provide a specific bandwidth of light to a specific waveguide. The optical input may be matched to one or more FSRs of one or more of the plurality of resonators. The optical input may interrogate the plurality of resonators. The optical input may be scanned over a wavelength range, such as as a function of time.

At an operation 1040, an optical output is detected from the plurality of resonators. The optical output may be a result of interrogation of the plurality of resonators. The optical output may be output along the same waveguide as the optical input is supplied. The optical output may be output along an output waveguide different from the waveguide used to supply the optical input. The optical output may be supplied parallel or antiparallel to the optical input. The optical output may correspond to the optical input with resonance peaks of the plurality of resonators subtracted (e.g., picked up by the plurality of resonators) from the optical input. The optical output may correspond to resonance peaks of the plurality of resonators, such as selectively picked up from the optical input. The optical output may be detected as a function of time and compared to wavelengths of an input source, in order to determine the optical output as a function of wavelength. The optical output may be detected as a function of wavelength.

At an operation 1050, resonance wavelengths of the plurality of resonators are determined based on the optical output. The resonance wavelengths may be determined by peak fitting. The resonance wavelengths may be determined based on one or more transforms, such as in frequency space. The resonance wavelengths may be determined based on maximums or minimums of intensity of the optical output and their corresponding wavelengths. The resonance wavelengths may be determined based on baseline resonance wavelengths (e.g., intended, expected, measured, calculated, etc.) resonance wavelengths of the plurality of resonators. Determining the resonance wavelengths may include determining wavelengths of transmission or reflection dips or peaks in the optical output and associating the determined wavelengths with a resonator of the plurality of resonators. The resonance wavelengths may be identified as corresponding to a given of the plurality of resonators. The resonance wavelengths may be identified as corresponding to a given of the plurality of detectors. The resonance wavelengths may be identified as corresponding to a given of the detected signals.

At an operation 1060, the signals detected by the plurality of detectors are determined, based on the resonance wavelengths. The signals detected by the plurality of detectors may be determined based on the difference between baseline resonance wavelengths and the detected resonance wavelengths of the plurality of resonators. The detected signals may be encoded, by the modulators, in the difference between the baseline resonance wavelengths and the detected resonance wavelengths and may be decoded. The signals detected by the plurality of detectors may be determined based on a resonance wavelength shift, a resonance intensity difference, etc. The signals detected by the plurality of detectors may be determined in any appropriate manner, such as those previously described. The signals detected by the plurality of detectors may be determined and used to create an image, such as of a scanning electron micrograph. The signals detected by the plurality of detectors may correspond to pixels of the image. The signals detected by the plurality of detectors may correspond to pixel values of the pixels of the image. The signals detected by the plurality of detectors may be acquired repeatedly, and such repeated signals may correspond to additional pixels of the image. The signals detected by the plurality of detectors may be used to construct, reconstruct, etc. information about a sample, where the signals detected by the plurality of detectors may be produced by interaction of particles with the sample.

As described above, method 1000 (and/or the other methods and systems described herein) is configured for detection of multiple particle beams.

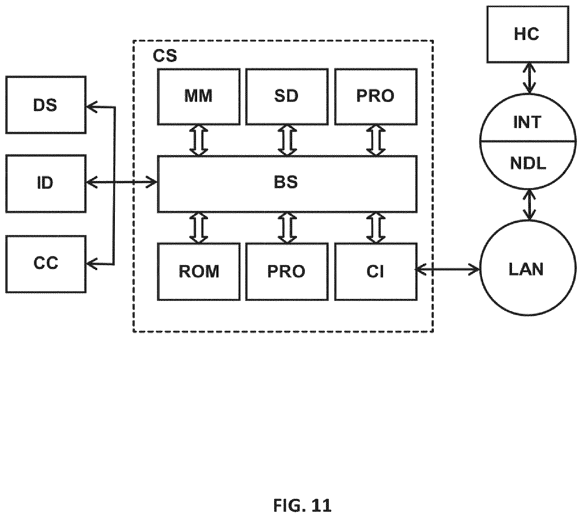

Figure 11 is a diagram of an example computer system CS that may be used for one or more of the operations described herein. Computer system CS includes a bus BS or other communication mechanism for communicating information, and a processor PRO (or multiple processors) coupled with bus BS for processing information. Computer system CS also includes a main memory MM, such as a random-access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" and/or "machine readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

Embodiments of the disclosure are defined in the following numbered clauses:

Clause 1: an optical multiplexer, comprising:

an optical waveguide;
a plurality of resonators optically coupled with the optical waveguide; and
a plurality of detectors, each detector of the plurality of detectors being associated with one of the resonators, each of the resonators being tuned to an individual resonance wavelength different from resonance wavelengths of other resonators of the plurality of resonators,
wherein each detector of the plurality of detectors is configured to change an optical path length or refractive index of the associated resonator.

Clause 2: the optical multiplexer of clause 1, wherein the detectors comprise particle detectors.
Clause 3: the optical multiplexer of clause 1, wherein the detectors are configured to detect a charge accumulated thereon over an accumulation time.
Clause 4: the optical multiplexer of any of the preceding clauses, wherein each detector comprises a modulator configured to modulate a detected signal and wherein the modulator is configured to change the optical path length or refractive index of the associated resonator based on the modulated signal.
Clause 5: the optical multiplexer of clause 4, wherein the modulator is an electro-optic modulator.
Clause 6: the optical multiplexer of clause 4, wherein the modulator is a thermal modulator.
Clause 7: the optical multiplexer of clause 4, wherein the modulator is based on a free-carrier effect.
Clause 8: the optical multiplexer of clause 1, wherein the detectors are configured to detect a plurality of particle beams, wherein each detector is configured to detect an associated one of the particle beams.
Clause 9: the optical multiplexer of clause 1, wherein the detectors are detectors of a scanning electron microscope (SEM).

Clause 10: the optical multiplexer of clause 1, further comprising an optical source configured to probe the plurality of resonators by supplying a wavelength of emitted light to the optical waveguide over a wavelength range and by scanning the wavelength of emitted light over the wavelength range.

Clause 11: the optical multiplexer of clause 10, wherein the optical source is a laser.

Clause 12: the optical multiplexer of clause 1, further comprising an optical source configured to probe the plurality of resonators, wherein the optical source is a broadband optical source.

Clause 13: the optical multiplexer of clause 1, further comprising an optical detector configured to detect intensity as a function of wavelength of light transmitted by the optical waveguide after interaction of the light in the optical waveguide with the plurality of resonators.

Clause 14: the optical multiplexer of clause 13 wherein the optical detector is a photodiode.

Clause 15: the optical multiplexer of clause 13, wherein the optical detector is configured to detect the intensity as a function of the wavelength by detecting intensity while scanning a detection window over a wavelength range.

Clause 16: the optical multiplexer of clause 1, wherein the resonators comprise ring resonators.

Clause 17: the optical multiplexer of clause 1, wherein the resonators comprise linear resonators.

Clause 18: the optical multiplexer of clause 1, wherein the resonators comprise photonic crystal nanocavities.

Clause 19: the optical multiplexer of clause 18, wherein the optical waveguide is a photonic crystal waveguide.

Clause 20: the optical multiplexer of clause 1, wherein the optical waveguide comprises an input optical waveguide coupled between a probing optical source and the plurality of resonators, and an output optical waveguide coupled between the plurality of resonators and an optical detector.

Clause 21: a method for detection of multiple particle beams comprising:

   detecting, by a plurality of detectors, signals corresponding to a received media;
   applying, by the plurality of detectors, the detected signals to a plurality of resonators;
   supplying, via an optical waveguide, an optical input to the plurality of resonators;
   detecting, via the optical waveguide, an optical output of the plurality of resonators;
   determining, based on the optical output, resonance wavelengths of the plurality of resonators; and
   determining, based on the resonance wavelengths, the signals detected by the plurality of detectors.

Clause 22: the method of clause 21, wherein each of the plurality of resonators is tuned to an individual resonance wavelength different from resonance wavelengths of other resonators.

Clause 23: the method of clause 21, wherein determining the detected signals comprises:

   determining, for each of the plurality of resonators, a relationship between the determined resonance wavelength and a baseline resonance wavelength; and
   determining, based on the relationship between the determined resonance wavelength and the baseline resonance wavelength, the detected signal applied to each of the plurality of resonators.

Clause 24: the method of clause 23, wherein determining the relationship between the determined resonance wavelength and a baseline resonance wavelength comprises determining a resonance wavelength shift.

Clause 25: the method of clause 23, wherein determining the relationship between the determined resonance wavelength and a baseline resonance wavelength further comprises determining a relationship between a determined resonance intensity and a baseline resonance intensity and wherein determining the detected signal further comprises determining the detected signal based on the relationship between the determined intensity and the baseline resonance intensity.

Clause 26: the method of clause 21, wherein detecting the signals corresponding to the received media further comprises modulating, by a plurality of modulators, the detected signals and wherein applying the detected signals to the plurality of resonators comprises applying, by the plurality of modulators, the modulated signals to the plurality of resonators.

Clause 27: the method of clause 21, wherein determining resonance wavelengths comprises determining wavelengths of transmission or reflection dips or peaks in the optical output associated with each of the plurality of resonators.

Clause 28: the method of clause 21, wherein supplying an optical input comprises supplying a wavelength of emitted light to the optical waveguide by a laser and scanning the wavelength of emitted light over a wavelength range.

Clause 29: the method of clause 21, wherein supplying an optical input comprises supplying a range of wavelengths of emitted light to the optical waveguide by a broadband optical source.

Clause 30: the method of clause 21, wherein the plurality of detectors comprises a plurality of particle detectors.

Clause 31: the method of clause 21, wherein signals corresponding to the received media comprise signals corresponding to electrons.

Clause 32: the method of clause 21, wherein signals corresponding to the received media comprise signals corresponding to photons.

Clause 33: the method of clause 21, wherein detecting, by the plurality of detectors, signals corresponding to the received media further comprises detecting, by the plurality of detectors, signals corresponding to particles incident on a plurality of detection areas, a given detection area within the plurality of detection areas corresponding to a given detector within the plurality of detectors and wherein determining, based on the resonance wavelengths, the signals further comprises determining, based on the resonance wavelengths, the signals corresponding to the particles incident on the plurality of detection areas.

Clause 34: the method of clause 21, further comprising:

constructing an image based on the signals detected by the plurality of detectors.

Clause 35: the method of clause 34, wherein constructing the image comprises determining pixel values for a plurality of pixels of the image based on the signals detected by the plurality of detectors.

Clause 36: the method of clause 21, further comprising:

supplying multiple particle beams through apertures in the plurality of detectors, a given detector within the plurality of detectors surrounding a path of a given particle beam of the plurality of particle beams.

Clause 37: the method of clause 36, wherein detecting the signals corresponding to the received media comprises detecting with the given detector particles after interaction of the particle beam with a sample.

Clause 38: the method of clause 36, wherein the multiple particle beams are substantially parallel.

Clause 39: an apparatus comprising:

the optical multiplexer of any one of clauses 1 to 20; and
a measurement system configured to measure a resonance wavelength for each of the plurality of resonators.

Clause 40: the apparatus of clause 39, wherein the measurement system is further configured to determine a signal from each detector based on a relationship between the tuned individual resonance wavelength and the measured resonance wavelength.

Clause 41: the apparatus of clause 40, further comprising:

a source configured to provide a beam of particles from which a multi-beam is derived;
wherein the plurality of detectors are configured to detect particles after interaction of the multi-beam with a sample.

Clause 42: the apparatus of clause 41, further comprising:

an objective lens array assembly, the objective lens array assembly configured to focus the multi-beam of sub-beams on the sample.

Clause 43: the apparatus of clause 42, wherein the objective lens array assembly further comprises:

an objective lens array defining a plurality of apertures aligned along sub-beam paths of the multi-beam and configured to project the multi-beam towards the sample.

Clause 44: the apparatus of clause 43, wherein the objective lens array further comprises the plurality of detectors, a given detector within the plurality of detectors surrounding a sub-beam path of the multi-beam.

Clause 45: the apparatus of clause 43, wherein the plurality of apertures are apertures within a substantially planar element of the objective lens array.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, one or more of the operations described above may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

**Claims**

1. An optical multiplexer, comprising:

an optical waveguide;

a plurality of resonators optically coupled with the optical waveguide; and

a plurality of detectors, each detector of the plurality of detectors being associated with one of the resonators, each of the resonators being tuned to an individual resonance wavelength different from resonance wavelengths of other resonators of the plurality of resonators,

wherein each detector of the plurality of detectors is configured to change an optical path length or refractive index of the associated resonator.

2. The optical multiplexer of claim 1, wherein the detectors comprise particle detectors.

3. The optical multiplexer of claim 1, wherein the detectors are configured to detect a charge accumulated thereon over an accumulation time.

4. The optical multiplexer of any of the preceding claims, wherein each detector comprises a modulator configured to modulate a detected signal and wherein the modulator is configured to change the optical path length or refractive index of the associated resonator based on the modulated signal.

5. The optical multiplexer of claim 4, wherein the modulator is an electro-optic modulator, or wherein the modulator is a thermal modulator, or wherein the modulator is based on a free-carrier effect.

6. The optical multiplexer of claim 1, wherein the detectors are configured to detect a plurality of particle beams, wherein each detector is configured to detect an associated one of the particle beams.

7. The optical multiplexer of claim 1, wherein the detectors are detectors of a scanning electron microscope (SEM).

8. The optical multiplexer of claim 1, further comprising an optical source configured to probe the plurality of resonators by supplying a wavelength of emitted light to the optical waveguide over a wavelength range and by scanning the wavelength of emitted light over the wavelength range.

9. The optical multiplexer of claim 1, further comprising an optical source configured to probe the plurality of resonators, wherein the optical source is a broadband optical source.

10. The optical multiplexer of claim 1, further comprising an optical detector configured to detect intensity as a function of wavelength of light transmitted by the optical waveguide after interaction of the light in the optical waveguide with the plurality of resonators.

11. The optical multiplexer of claim 1, wherein the resonators comprise ring resonators, or wherein the resonators comprise linear resonators, or wherein the resonators comprise photonic crystal nanocavities.

12. The optical multiplexer of claim 1, wherein the optical waveguide comprises an input optical waveguide coupled between a probing optical source and the plurality of resonators, and an output optical waveguide coupled between the plurality of resonators and an optical detector.

13. A method for detection of multiple particle beams comprising:

detecting, by a plurality of detectors, signals corresponding to a received media;
applying, by the plurality of detectors, the detected signals to a plurality of resonators;
supplying, via an optical waveguide, an optical input to the plurality of resonators;
detecting, via the optical waveguide, an optical output of the plurality of resonators;
determining, based on the optical output, resonance wavelengths of the plurality of resonators; and
determining, based on the resonance wavelengths, the signals detected by the plurality of detectors.

14. An apparatus comprising:

the optical multiplexer of any one of claims 1 to 12; and
a measurement system configured to measure a resonance wavelength for each of the plurality of resonators.

15. The apparatus of claim 14, wherein the measurement system is further configured to determine a signal from each detector based on a relationship between the tuned individual resonance wavelength and the measured resonance

wavelength.

100

130a

130b

130

120

140

110

150

FIG. 1

FIG. 2

**FIG. 3**

FIG. 4A

FIG. 4B

FIG. 5

FIG. 6A

FIG. 6B

FIG. 6C

FIG. 7A

FIG. 7B

FIG. 7C

FIG. 8A

FIG. 8B

FIG. 8C

FIG. 8D

FIG. 8E

FIG. 8F

EP 4 394 841 A1

FIG. 9

1000

```
┌─────────────────────┐
│        1010         │
└─────────────────────┘
           │
           ▼
┌─────────────────────┐
│        1020         │
└─────────────────────┘
           │
           ▼
┌─────────────────────┐
│        1030         │
└─────────────────────┘
           │
           ▼
┌─────────────────────┐
│        1040         │
└─────────────────────┘
           │
           ▼
┌─────────────────────┐
│        1050         │
└─────────────────────┘
           │
           ▼
┌─────────────────────┐
│        1060         │
└─────────────────────┘
```

**FIG. 10**

FIG. 11

Europäisches
Patentamt

European
Patent Office

Office européen
des brevets

**EUROPEAN SEARCH REPORT**

Application Number

EP 22 21 7433

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 284 824 B2 (CAELESTE CVBA [BE]) 7 May 2019 (2019-05-07) * the whole document * | 1-15 | INV. H01J37/244 |
| A | US 7 764 850 B2 (HEWLETT PACKARD DEVELOPMENT CO [US]) 27 July 2010 (2010-07-27) * column 3, line 12 – column 5, line 3; figures * | 1,4,5,11 | |
| A | "SEMICONDUCTOR CHARGED PARTICLE DETECTOR FOR MICROSCOPY", RESEARCH DISCLOSURE, KENNETH MASON PUBLICATIONS, HAMPSHIRE, UK, GB , vol. 685, no. 82 1 May 2021 (2021-05-01), XP007149412, ISSN: 0374-4353 Retrieved from the Internet: URL:https://www.researchdisclosure.com/database/RD685082 * paragraph [0071]; figures * | 7 | |
| A | Lasse Juhana Kauppinen: "COMPACT INTEGRATED OPTICAL DEVICES FOR OPTICAL SENSOR AND SWITCHING APPLICATIONS", PhD Thesis, 1 January 2010 (2010-01-01), pages 1-126, XP055538648, Retrieved from the Internet: URL:http://dx.doi.org/10.3990/1.9789036530880 [retrieved on 2019-01-07] * page 59 – page 84 * | 1,4,5, 8-15 | |

TECHNICAL FIELDS SEARCHED (IPC)

H01J
G02B
G01T

-/--

The present search report has been drawn up for all claims

| Place of search | Date of completion of the search | Examiner |
|---|---|---|
| Munich | 14 June 2023 | Schmidt-Kärst, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 ...........................................................................

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 22 21 7433

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SINATKAS GEORGIOS ET AL: "Electro-optic modulation in integrated photonics", JOURNAL OF APPLIED PHYSICS, AMERICAN INSTITUTE OF PHYSICS, 2 HUNTINGTON QUADRANGLE, MELVILLE, NY 11747, vol. 130, no. 1, 2 July 2021 (2021-07-02), XP012257868, ISSN: 0021-8979, DOI: 10.1063/5.0048712 [retrieved on 2021-07-02] * the whole document * | 1,4,5, 8-15 | |

TECHNICAL FIELDS
SEARCHED (IPC)

The present search report has been drawn up for all claims

| Place of search | Date of completion of the search | Examiner |
|---|---|---|
| Munich | 14 June 2023 | Schmidt-Kärst, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 21 7433

This annex lists the patent family members relating to the patent documents cited in  the above-mentioned European search report.
The members are as contained in the European Patent Office EDP file on
The European Patent Office is in no way liable for these particulars which are merely given for the purpose of information.

14-06-2023

| Patent document cited in search report | | Publication date | Patent family member(s) | Publication date |
|---|---|---|---|---|
| US 10284824 | B2 | 07-05-2019 | NONE | |
| US 7764850 | B2 | 27-07-2010 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO IB2010051848 A

- EP 2021080509 W